# EUROPÄISCHE PATENTSCHRIFT

(11) **EP 3 625 588 B1**
(45) Veröffentlichungstag und Bekanntmachung des Hinweises auf die Patenterteilung: **09.10.2024**
(21) Anmeldenummer: 18723848.0
(22) Anmeldetag: 16.05.2018
(51) Int. Cl.: G01S 15/931, G01S 15/87, G01S 7/02, G01S 7/527, G01S 13/86, G01S 7/00, G01S 7/533, G01S 7/52, G01S 7/539, H03M 7/30

(54) **VERFAHREN ZUR ÜBERTRAGUNG VON DATEN ÜBER EINEN FAHRZEUGDATENBUS VON EINEM ULTRASCHALLSYSTEM ZU EINER DATENVERARBEITUNGSVORRICHTUNG**
METHOD FOR TRANSMITTING DATA VIA A VEHICLE DATA BUS FROM AN ULTRASOUND SYSTEM TO A DATA PROCESSING APPARATUS
PROCÉDÉ DE TRANSMISSION DE DONNÉES VIA UN BUS DE DONNÉES DE VÉHICULE PROVENANT D'UN SYSTÈME À ULTRA-SONS À UN DISPOSITIF INFORMATIQUE

(30) Priorität: 16.05.2017 EP 17171320; 16.03.2018 DE 102018106241
(43) Veröffentlichungstag der Anmeldung: 25.03.2020
(73) Patentinhaber: Elmos Semiconductor SE, 44227 Dortmund (DE)
(72) Erfinder: KREISS, Dennis, 30559 Hannover (DE)
(74) Vertreter: dompatent von Kreisler Selting Werner - Partnerschaft von Patent- und Rechtsanwälten mbB
(86) Internationale Anmeldenummer: PCT/EP2018/062808
(87) Internationale Veröffentlichungsnummer: WO 2018/210966

(56) Entgegenhaltungen:
- EP-A1- 2 455 779
- DE-A1- 10 106 142
- DE-A1- 102009 027 842
- DE-A1- 102010 041 424
- DE-A1- 102010 044 993
- DE-A1- 102012 200 017
- DE-A1- 102013 015 402
- DE-A1- 102015 104 940
- DE-A1- 19 707 651
- JP-A- 2003 194 921
- US-A1- 2004 204 812
- US-A1- 2012 120 768
- "Wavelet", 22 March 2017 (2017-03-22), XP002785208, Retrieved from the Internet <URL:https://de.wikipedia.org/w/index.php?title=Wavelet&oldid=163843365> [retrieved on 20180927]

## Beschreibung

Die Erfindung betrifft ein Verfahren und System zur Übertragung von Daten über einen Fahrzeugdatenbus (uni- bzw. bidirektionaler Ein-, Zwei- oder Mehrdraht-Datenbus, gegebenenfalls differentiell) von einem Ultraschallsystem mit mindestens zwei Sensoren mit jeweils einem Ultraschallsender und einem Ultraschallempfänger an eine Datenverarbeitungsvorrichtung. Insbesondere betrifft die Erfindung ein Verfahren zur Klassifikation eines Echosignals eines Ultraschallsystems in einem Fahrzeug zwecks Datenkompression und Übertragung der komprimierten Daten von dem Ultraschallsystem an eine Datenverarbeitungsvorrichtung.

Ultraschallsysteme werden bereits seit geraumer Zeit in Fahrzeugen für die Umfelderkennung eingesetzt. Dabei werden von mindestens einem Ultraschallsender Ultraschall-Burstsignale ausgesendet, die nach Reflektion an einem Hindernis (allgemein Objekt) von mindestens einem Ultraschallempfänger des Ultraschallsystems empfangen werden. Als Ultraschallsender/Ultraschallempfänger wird überwiegend ein sogenannter Ultraschalltransducer eingesetzt, der in einer ersten Phase als Sender und in einer späteren zweiten Phase eines Abfrageintervalls als Ultraschallempfänger arbeitet.

Die Anforderungen an das Erkennen von Hindernissen bzw. Objekten im Umfeld eines Fahrzeugs durch Ultraschallsysteme sind in den letzten Jahren stetig gestiegen. War es früher eventuell ausreichend, lediglich zu wissen, dass sich in einem bestimmten Abstand zum Fahrzeug ein Hindernis befindet, so ist man heute bestrebt, anhand des Echosignalverlaufs zu rekonstruieren, welche Art von Hindernis sich im Umfeld des Fahrzeugs befindet.

Dadurch aber steigt die Menge an zwischen einem Ultraschallsystem und einer Datenverarbeitungsvorrichtung des Fahrzeugs zu übertragenden Daten. Die herkömmlicherweise in Fahrzeugen verwendeten Datenbusse weisen jedoch nicht zuletzt aus Kostengründen lediglich eine begrenzte maximale Datenübertragungsrate auf.

Daher ist man in der Vergangenheit bereits dazu übergegangen, die Menge an zu übertragenden Daten zu reduzieren. Dies erfolgt mitunter durch Hindernisobjekterkennung (mit entsprechenden Konfidenzinformationen für die Zuverlässigkeit der Hinderniserkennung), wie es beispielsweise in DE-A-10 2008 042 640 beschrieben ist. Weitere Beispiele für den Einsatz von Ultraschallsystemen mit der Möglichkeit der Reduktion der Datenübertragung finden sich in DE-A-10 2005 024 716 und DE-A-10 2012 207 164.

Es besteht der Wunsch, mehr und mehr Daten des eigentlichen Messsignals des Ultraschallsensors an ein zentrales Rechnersystem zu übertragen, in dem diese mit Daten von anderen Ultraschallsensorsystemen und/oder auch von andersartigen Sensorsystemen, z.B. Radarsystemen, also durch Sensor-Fusion zu sogenannten Umgebungs- oder Umweltkarten weiterverarbeitet werden. Es besteht daher der Wunsch, eine Objekterkennung nicht im Ultraschallsensorsystem selbst, sondern erst durch eben diese Sensorfusion im Rechnersystem vorzunehmen, um Datenverluste zu vermeiden und so die Wahrscheinlichkeit für Fehlinformationen und daraus resultierenden Fehlentscheidungen und somit die Gefahr von Unfällen zu reduzieren. Gleichzeitig ist aber die Übertragungsbandbreite der verfügbaren Sensordatenbusse begrenzt. Deren Austausch soll vermieden werden, da sie sich im Feld bewährt haben. Es besteht daher gleichzeitig der Wunsch, die Menge der zu übertragenden Daten nicht ansteigen zu lassen. Kurzum: Der Informationsgehalt der Daten und deren Relevanz für die spätere im Rechnersystem ablaufende Hinderniserkennung (d. h. Objekterkennung) muss gesteigert werden, ohne die Datenrate zu sehr anheben zu müssen, besser noch ohne die Datenrate überhaupt vergrößern zu müssen. Ganz im Gegenteil sollte der Datenratenbedarf bevorzugterweise sogar gesenkt werden, um Datenratenkapazitäten für die Übermittlung von Statusdaten und Selbsttestinformationen des Ultraschallsensorsystems an das Rechnersystem zuzulassen, was im Rahmen der Funktionalen Sicherheit (FuSi) zwingend erforderlich ist. Diesem Problem widmet sich die hier vorgelegte Erfindung.

Im Stand der Technik sind bereits verschiedene Methoden der Verarbeitung eines Ultraschallsensorsignals bekannt.

Aus WO-A-2012/016 834 ist beispielsweise ein Verfahren zur Auswertung eines Echosignals zur Fahrzeugumfelderfassung bekannt. Es wird dort vorgeschlagen, ein Messsignal mit einer vorgebbaren Codierung und Form auszusenden und in dem Empfangssignal mittels einer Korrelation mit dem Messsignal nach Anteilen des Messsignals im Empfangssignal zu suchen und diese zu bestimmen. Der Pegel der Korrelation (und nicht der Pegel der Hüllkurve des Echosignals) wird dann mit einem Schwellwert bewertet.

Aus DE-A-4 433 957 ist es bekannt, zur Hinderniserkennung Ultraschallimpulse periodisch auszustrahlen und aus der Laufzeit auf die Position von Hindernissen zu schließen, wobei bei der Bewertung zeitlich über mehrere Messzyklen korreliert verbleibende Echos verstärkt werden, während unkorreliert verbleibende Echos unterdrückt werden.

Aus DE-A-10 2012 015 967 ist ein Verfahren zum Dekodieren eines von einem Ultraschallsensor eines Kraftfahrzeugs empfangenen Empfangssignals bekannt, bei welchem ein Sendesignal des Ultraschallsensors kodiert ausgesendet wird und zur Dekodierung das Empfangssignal mit einem Referenzsignal korreliert wird, wobei vor der Korrelation des Empfangssignals mit dem Referenzsignal eine Frequenzverschiebung des Empfangssignals gegenüber dem Sendesignal bestimmt wird und das Empfangssignal mit dem um die ermittelte Frequenzverschiebung in seiner Frequenz verschobenen Sendesignal als Referenzsignal korreliert wird, wobei zur Bestimmung der Frequenzverschiebung des Empfangssignals selbiges einer Fourier-Transformation unterzogen und die Frequenzverschiebung anhand eines Ergebnisses der Fourier-Transformation bestimmt wird.

Aus DE-A-10 2011 085 286 ist ein Verfahren zur Erfassung der Umgebung eines Fahrzeugs mittels Ultraschall bekannt, wobei Ultraschallpulse ausgesendet sowie die an Objekten reflektierten Ultraschallechos detektiert werden und der Erfassungsbereich in mindestens zwei Entfernungsbereiche unterteilt ist und wobei die für die Erfassung im jeweiligen Entfernungsbereich verwendeten Ultraschallpulse voneinander unabhängig ausgesendet werden und durch verschiedene Frequenzen kodiert sind.

Aus WO-A-2014/108300 sind eine Vorrichtung und ein Verfahren zur Umfelderfassung mittels eines Signalwandlers und einer Auswerteeinheit bekannt, wobei aus dem Umfeld empfangener Signale mit einer ersten Impulsantwortlänge zu einem ersten Zeitpunkt während eines Messzyklus und mit einer zweiten größeren Impulsantwortlänge zu einem zweiten späteren Zeitpunkt innerhalb desselben Messzyklus Signale laufzeitabhängig gefiltert werden.

Die technischen Lehren der obigen Schutzrechte sind jedoch allesamt von dem Gedanken geleitet, die Erkennung eines mit Hilfe des Ultraschallsensors erfassten Hindernisses (Objekts) bereits im Ultraschallsensor selbst durchzuführen und dann erst die Objektdaten nach Erkennung des Objekts zu übertragen. Hierbei gehen jedoch Synergieeffekte bei der Verwendung mehrerer Ultraschallsender verloren.

Aus DE-A-197 07 651, DE-A-10 2010 044 993, DE-A-10 2012 200 017, DE-A-10 2013 015 402 und EP-A-2 455 779 sind diverse Verfahren zur (teilweisen Vor-)Verarbeitung von Signalen von Ultraschallsensoren mit anschließender Übertragung dieser Signale bekannt.

Aus DE-A-10 2010 041 424 ist ein Verfahren zur Übertragung von Daten über einen Fahrzeugdatenbus von einem Ultraschallsystem mit mindestens zwei Sensoren mit jeweils einem Ultraschallsender und einem Ultraschallempfänger an ein eine Datenverarbeitungsvorrichtung aufweisendes Rechnersystem zur Verarbeitung der übertragenden Daten bekannt, wobei die Daten als komprimierte Echo-Informationen an das Rechnersystem übertragen werden.

Aufgabe der Erfindung ist es, den Grad der Datenkomprimierung in einem Ultraschallsystem eines Fahrzeugs weiter zu erhöhen, ohne dass dadurch die Zuverlässigkeit der Erkennung von Hindernissen und des Typs von Hindernissen leidet. Eine weitere Aufgabe ist es, den Bedarf an Busbandbreite für die Übertragung von Messdaten von einem Ultraschallsensorsystem zu einem Rechnersystem weiter zu senken bzw. die Effizienz der Datenübertragung zu steigern. Zur Lösung dieser Aufgabe wird mit der Erfindung ein Verfahren zur Übertragung von Daten über einen Fahrzeugdatenbus von einem Ultraschallsystem mit mindestens zwei Sensoren mit jeweils einem Ultraschallsender und einem Ultraschallempfänger an eine Datenverarbeitungsvorrichtung vorgeschlagen, wobei bei dem Verfahren so, wie im Anspruch 1 angegeben, vorgegangen wird. Die Merkmale des erfindungsgemäßen Sensorsystems sind in Anspruch 5 genannt. Einzelne Ausgestaltungen des Verfahrens und des Sensorsystems sind Gegenstand der Unteransprüche.

Der Grundgedanke der Erfindung umfasst dabei die Erkennung von potenziell relevanten Strukturen im Messsignal und die Kompression dieses Messsignals durch Übertragung nur von wenigen Daten zu diesen erkannten, potenziell relevanten Strukturen anstelle des Messsignals selbst. Die eigentliche Erkennung von Objekten, z.B. Hindernissen für den Einparkvorgang, findet nach Dekomprimierung der die Echosignalabschnitte der Signalverlaufsobjekte repräsentierenden, komprimierten Echosignalabschnittsdaten und somit anhand des dadurch rekonstruierten Ultraschallempfangssignals im Rechnersystem statt, in dem typischerweise mehrere komprimierte Echosignalabschnittsdaten mehrerer Ultraschallsensoren zusammenkommen (und dekomprimiert werden). Die Erfindung betrifft also im Speziellen die Kompression der Daten durch Strukturerkennung im Messsignal.

Nach dem erfindungsgemäßen Vorschlag werden also die Echosignale auf das Vorhandensein bestimmter, vorgegebener Signalverlaufscharakteristika untersucht, um dann diese Signalverlaufscharakteristika repräsentierende Daten zu übertragen, wobei dann in der Datenverarbeitungsvorrichtung des Fahrzeugs aus diesen Echosignaldaten weitere Schlussfolgerungen gezogen werden können. Beispielsweise könnte man das Echosignal wiederherstellen bzw. bei wiederholtem Erkennen gleicher gegebenenfalls zeitversetzt erfolgender Signalverlaufscharakteristika auf ein Hindernis, auf den Typ des Hindernisses, auf die Veränderung des Abstands des Fahrzeugs zum Hindernis etc. zu schließen. Wichtig dabei ist, dass die Aufgabe, ein Hindernis zu erkennen, von dem Ultraschallsystem weg hin zur Datenverarbeitungsvorrichtung verschoben wird, was die Anforderungen an die "Intelligenz" der Komponenten des Ultraschallsystems verringert, womit einhergehend die Menge an von dem Ultraschallsystem an die Datenverarbeitungsvorrichtung zu übertragenden Daten reduziert werden kann, da die eigentliche Analyse der Echosignaldaten dahingehend, welches Hindernis sich im Umfeld des Fahrzeugs befindet und wie sich dieses Hindernis innerhalb des Fahrzeugumfeldes verändert (insbesondere hinsichtlich seines Abstands zum Fahrzeug) in der Datenverarbeitungsvorrichtung erfolgt.

Nach der Erfindung ist vorgesehen, ein empfangenes Echosignal auf das Vorhandensein bestimmter vordefinierter Signalverlaufscharakteristika hin zu untersuchen. Einzelne oder mehrere dieser Signalverlaufscharakteristika definieren einen speziellen Signalverlauf, was nachfolgend als Signalverlaufsobjekt bezeichnet wird. Es existieren mehrere Objektklassen, wobei nun das identifizierte Signalverlaufsobjekt einer dieser Objektklassen zugeordnet wird. Jede Objektklasse ist mit einer Kennung versehen. Ferner wird erfindungsgemäß mindestens ein Objektparameter bestimmt, der das identifizierte Signalverlaufsobjekt weiter beschreibt bzw. charakterisiert. Mögliche Objektparameter umfassen z. B.:
- den auf einen Referenzzeitpunkt bezogenen Auftrittzeitpunkt des Signalverlaufsobjekts,
- die zeitliche Ausdehnung des Signalverlaufsobjekts,
- den zeitlichen Abstand zu einem im Echosignal vorauseilenden oder nachfolgenden Signalverlaufsobjekt und/oder
- die Größe, die Höhe und insbesondere die Maximalhöhe des Signalverlaufsobjekts,
- den Zeitpunkt der Höhe und insbesondere den Zeitpunkt der maximalen Höhe des Signalverlaufsobjekts innerhalb von dessen zeitlicher Ausdehnung und/oder
- die Größe der Fläche (Integrals) des zum Signalverlaufsobjekt gehörenden Echosignalabschnitts und
- insbesondere die Größe des oberhalb eines Schwellwerts oder eines Schwellwertsignalverlaufs liegenden Anteils der Fläche (Integrals) des zum Signalverlaufsobjekt gehörenden Echosignalabschnitts.

Aus der Kennung für die Signalverlaufsobjektklasse und dem oder den zu einem Signalverlaufsobjekt ermittelten Objektparameter lässt sich der zum Signalverlaufsobjekt gehörende Echosignalabschnitt in der Datenverarbeitungsvorrichtung rekonstruieren. Auf diese Weise lässt sich der einem identifizierten Signalverlaufsobjekt zu Grunde liegende Echosignalabschnitt, der an sich durch seine (digitalen) Abtastwerte an die Datenverarbeitungsvorrichtung übertragen werden müsste, nun komprimiert übertragen, also unter Verwendung deutlich weniger Daten an die Datenverarbeitungsvorrichtung. Übertragen werden erfindungsgemäß sogenannte Echosignalabschnittsdaten, bei denen es sich zumindest um die Kennung der Signalverlaufsobjektklasse und den mindestens einen, das Signalverlaufsobjekt beschreibenden Objektparameter handelt. Im Bedarfsfalle können noch weitere Daten mitübertragen werden, worauf später noch eingegangen werden wird.

Gemäß der Erfindung ist vorgesehen, dass das Ultraschallsystem mehrere Ultraschallsender und mehrere Ultraschallempfänger aufweist und dass über den Fahrzeugdatenbus die Echosignalabschnittsdaten, die aus mehreren in einem vorgebbaren Zeitfenster empfangenen Echosignalen jeweils identifizierte Signalverlaufsobjekten repräsentieren, an die Datenverarbeitungsvorrichtung zwecks Erkennung eines Hindernisses und/oder des Abstandes eines Hindernisses zu mindestens einem Ultraschallempfänger oder einem der Ultraschallempfänger des Ultraschallsystems übertragen werden.

Wie bereits oben erwähnt, können neben der Kennung der Signalverlaufsobjektklasse und dem oder den Objektparametern weitere Daten als Echosignalabschnittsdaten übertragen werden. Mit Vorteil kann hierbei vorgesehen sein, dass über den Fahrzeugdatenbus von der Ultraschallmessvorrichtung an die Datenverarbeitungsvorrichtung zusätzlich zu den Echosignalabschnittsdaten auch den jeweiligen identifizierten Signalverlaufsobjekten zugeordnete Konfidenzwerte übertragen werden.

Bei den erfindungsgemäß im Echosignal aufzusuchenden Signalverlaufscharakteristika handelt es sich zweckmäßigerweise um ein oberhalb eines Schwellwerts oder eines Schwellwertsignals liegenden lokalen Extremwert des Echosignals mit Auftrittzeitpunkt, ein oberhalb eines Schwellwerts oder eines Schwellwertsignals liegenden absoluten Extremwert des Echosignals mit Auftrittzeitpunkt, ein oberhalb eines Schwellwerts oder eines Schwellwertsignals liegenden absoluten Extremwert des Echosignals mit Auftrittzeitpunkt, ein oberhalb eines Schwellwerts oder eines Schwellwertsignals liegenden Sattelpunkt des Echosignals mit Auftrittzeitpunkt, ein bei größer werdendem Signalpegel des Echosignals erfolgendes Überschreiten eines oder des Schwellwerts oder eines oder des Schwellwertsignals mit Überschreitungszeitpunkt und/oder ein bei kleiner werdendem Signalpegel des Echosignals erfolgendes Unterschreiten eines oder des Schwellwerts oder eines oder des Schwellwertsignals mit Unterschreitungszeitpunkt oder vorgebbare Kombinationen aus ein oder mehreren der zuvor genannten Signalverlaufscharakteristika, die zeitlich aufeinanderfolgend auftreten.

Vorzugsweise kann ferner vorgesehen sein, dass zu den Signalverlaufscharakteristika oder zu den Objektparametern auch gehört, ob und, wenn ja, wie das empfangene Echosignal moduliert ist, und zwar beispielsweise mit monoton steigender oder streng monoton steigender Frequenz (Chirp-Up), beispielsweise mit monoton fallender oder streng monoton fallender Frequenz (Chirp-Down) oder beispielsweise mit gleichbleibender Frequenz (No-Chirp). In diesem Zusammenhang sei auf DE-B-10 2017 123 049, DE-B-10 2017 123 051, DE-B-10 2017 123 052 und DE-B-10 2017 123 050 verwiesen, deren Inhalte hiermit durch Bezugnahme zum Gegenstand der Erfindung gehören.

Andere Frequenzmodulationsverfahren oder allgemein andere Modulationsverfahren können ebenfalls Anwendung finden. Hier bietet sich beispielsweise eine Modulation der Ultraschallsignale durch Kodierung verschiedenster Art an. Vorteilhaft werden dopplereffektfeste Kodierungen eingesetzt. Allgemein kann man sagen, dass zu der Kodierung gehört, dass diese als ein vorgegebenes Wavelet aufgefasst werden kann, dessen zeitlicher Mittelwert insbesondere auch von Null verschieden sein kann.

Bei einer weiteren vorteilhaften Ausgestaltung der Erfindung ist vorgesehen, dass mehrere Ultraschallsender des Ultraschallsystems unterschiedlich modulierte Ultraschallsignale aussenden, dass die von den Ultraschallempfängern gesendeten Echosignalabschnittsdaten auch eine Kennung der Modulation des jeweils empfangenen Echosignals umfassen und dass anhand der Kennung der Modulation in der Datenverarbeitungsvorrichtung ermittelbar ist, von welchem Ultraschallsender das Ultraschallsendesignal gesendet worden ist, das als Echosignal oder Echosignalanteil durch einen Ultraschallempfänger, der an die Datenverarbeitungsvorrichtung zu diesem Echosignal oder Echosignalanteil Echosignalabschnittsdaten überträgt, empfangen worden ist.

Der Vorteil des erfindungsgemäßen Verfahrens kommt insbesondere dadurch zum Tragen, dass das Ultraschallsystem mehrere Ultraschallsender und mehrere Ultraschallempfänger aufweist, wobei über den Fahrzeugdatenbus die Echosignaldaten, die die aus mehreren in einem vorgebbaren Zeitfenster empfangenen Echosignale jeweils extrahierten Signalverlaufscharakteristika repräsentieren, an die Datenverarbeitungsvorrichtung übertragen werden. Die Datenverarbeitungsvorrichtung empfängt nun in einem vorgebbaren Messzeitfenster von mehreren Ultraschallempfängern empfangene Echosignale bzw. die diese Echosignale beschreibenden Echosignaldaten der in diesen Echosignalen detektierten Signalverlaufscharakteristika. Wenn beispielsweise benachbart angeordnete Ultraschallempfänger ähnliche Echosignale empfangen, so kann dies zur Klassifizierung eines Hindernisses genutzt werden. Es hat sich herausgestellt, dass es wesentlich effizienter ist, die Erkennung des Typs eines Hindernisses anhand mehrerer komprimierter Echosignale mehrerer Ultraschallempfänger zu ermitteln, als wenn jedes Echosignal jedes Ultraschallempfängers zunächst für sich betrachtet untersucht wird, um auf den Typ eines Hindernisses zu schließen, um dann gegebenenfalls die daraus gewonnenen Erkenntnisse über den Typ des Hindernisses untereinander abzugleichen.

Bei dem erfindungsgemäßen Verfahren wird also sozusagen ein Feature-Vektor des Echosignals erzeugt, der Signalverlaufscharakteristika mit zugehörigen Zeitpunkten im Verlauf des Echosignals enthält. Der Feature-Vektor beschreibt also einzelne Abschnitte des Echosignals sowie Ereignisse im Echosignal, wobei noch keine Hinderniserkennung o.dgl. erfolgt.

Nach der Erfindung kann auch vorgesehen sein, aus dem Echosignal ein Hüllkurvensignal zu bilden, das Teil des Feature-Vektors ist bzw. von dem Teile Bestandteil des Feature-Vektors sein können. Auch ist es möglich, das empfangene Echosignal mit dem zugehörigen Ultraschallsendesignal zu falten, also mit dem Ultraschallsignal zu falten, das nach Reflektion als Echosignal empfangen worden ist, und so ein Korrelationssignal zu bilden, dessen Charakteristika Teil des Feature-Vektors sein können.

Die Signalverlaufscharakteristika beschreibenden Echosignaldaten können mit Vorteil Parameterdaten umfassen. Ein Parameterdatum kann dabei bevorzugt ein Zeitstempel sein, der angibt, wann im Echosignalverlauf das bzw. ein Charakteristikum aufgetreten ist. Der Zeitbezug (d. h. Referenzzeitpunkt) des Zeitstempels ist beliebig, aber für das System aus Ultraschallsystem und Datenverarbeitungsvorrichtung vordefiniert. Ein weiterer Parameter kann die Amplitude und/oder die Streckung o.dgl. eines ein Signalverlaufscharakteristikum beschreibenden Abschnitts des Echosignals sein. An dieser Stelle sei erwähnt, dass im Folgenden der Begriff "Amplitude" allgemein zu verstehen ist und beispielsweise für den (aktuellen) Signalpegel eines Signals und/oder für einen Spitzenwert des Signals verwendet wird.

Die erfindungsgemäß erzielte Kompression der zu übertragenden Daten über den Datenbus zwischen dem Ultraschallsystem und der Datenverarbeitungsvorrichtung senkt zum einen die Datenbuslast und damit die Kritizität gegenüber EMV-Anforderungen und schafft zum anderen freie Datenbuskapazitäten während der Empfangszeiten der Echosignale, wobei diese freien Datenbuskapazitäten dann für die Übertragung von Steuerbefehlen von der Datenverarbeitungsvorrichtung zum Ultraschallsystem und zur Übertragung von Statusinformationen und sonstigen Daten des Ultraschallsystems zur Datenverarbeitungsvorrichtung genutzt werden können. Eine mit Vorteil einzusetzende Priorisierung zu übertragender Daten garantiert dabei, dass sicherheitsrelevante Daten zuerst übertragen werden und somit keine unnötigen Totzeiten für Echosignaldaten entstehen.

Gemäß der Erfindung wird vorgesehen, dass das Ultraschallsystem mehrere Ultraschallsender und mehrere Ultraschallempfänger aufweist und dass über den Fahrzeugdatenbus die Echosignaldaten, die die aus mehreren in einem vorgebbaren Zeitfenster empfangenen Echosignale jeweils extrahierten Signalverlaufscharakteristika repräsentieren, an die Datenverarbeitungsvorrichtung übertragen werden.

Gemäß einer vorteilhaften Ausgestaltung der Erfindung kann vorgesehen sein, dass über den Fahrzeugdatenbus von der Ultraschallmessvorrichtung an die Datenverarbeitungsvorrichtung zusätzlich zu den Echosignaldaten auch den jeweiligen extrahierten Signalverlaufscharakteristika zugeordnete Konfidenzwerte übertragen werden.

Gemäß einer weiteren vorteilhaften Ausgestaltung der Erfindung kann vorgesehen sein, dass ein Signalverlaufscharakteristikum ein lokaler Extremwert des Echosignals mit Zeitpunkt, ein absoluter Extremwert des Echosignals mit Zeitpunkt, ein Sattelpunkt des Echosignals mit Zeitpunkt, ein bei größer werdendem Signalpegel des Echosignals erfolgendes Überschreiten eines Schwellwerts mit Überschreitungszeitpunkt und/oder ein bei kleiner werdendem Signalpegel des Echosignals erfolgendes Unterschreiten eines Schwellwerts mit Unterschreitungszeitpunkt ist. Ein Signalverlaufscharakteristikum kann aber ebenso auch eine zeitliche Aufeinanderfolgende (mit vorgebbarer Reihenfolge) mehrerer der zuvor genannten Signalverlaufscharakteristika sein.

Ferner kann gemäß einer vorteilhaften Ausgestaltung der Erfindung vorgesehen sein, dass zu den Signalverlaufscharakteristika auch gehört, ob und, wenn ja, wie das empfangene Echosignal moduliert ist, und zwar beispielsweise mit monoton steigender Frequenz (Chirp-Up), beispielsweise mit monoton abfallender Frequenz (Chirp-Down) oder beispielsweise mit gleichbleibender Frequenz (No-Chirp).

Gemäß einer weiteren vorteilhaften Ausgestaltung der Erfindung kann vorgesehen sein, dass mehrere Ultraschallsender des Ultraschallsystems modulierte Ultraschallsignale aussenden und dass anhand der Modulation des Echosignals ermittelbar ist, von welchem Ultraschallsender das als Echosignal oder Echosignalanteil durch einen Ultraschallempfänger empfangene Ultraschallsendesignal gesendet worden ist.

Mit der Erfindung wird also ein Verfahren zur Übertragung von Sensordaten von mindestens zwei Sensoren zu einem Rechnersystem vorgeschlagen. Besonders geeignet ist das erfindungsgemäße Verfahren in seiner Verwendung zur Übertragung von Daten von Ultraschallempfangssignalen von Ultraschallempfängern (nachfolgend Ultraschallsensoren genannt) an ein Steuergerät (als Rechnersystem bzw. Datenverarbeitungsvorrichtung) in einem Fahrzeug. Gemäß einer Variante der Erfindung wird zunächst ein Ultraschall-Bursts erzeugt und in einen Freiraum, typischerweise im Umfeld des Fahrzeugs ausgesendet. Ein Ultraschall-Burst besteht dabei aus mehreren mit Ultraschallfrequenz aufeinanderfolgenden Schallpulsen.

Dieser Ultraschall-Burst entsteht dadurch, dass ein mechanischer Schwinger anschwingt und wieder ausschwingt. Der so ausgesendete Ultraschall-Burst wird dann an Objekten (z.B. Hindernissen) reflektiert und durch einen Empfänger als Ultraschallsignal empfangen sowie in ein Empfangssignal umgewandelt. Besonders bevorzugt ist der Ultraschallsender identisch mit dem Ultraschallempfänger und wird im Folgenden dann als Transducer bezeichnet, der abwechselnd als Ultraschallsender und -empfänger arbeitet. Das im Folgenden erläuterte Prinzip lässt sich aber auch für getrennte Empfänger und Sender anwenden.

Jedem Ultraschallsensor zugeordnet ist eine Signalverarbeitungseinheit, die das Empfangssignal hinsichtlich vorgebbarer bzw. vorgegebener Signalverlaufscharakteristika analysiert, um die notwendige Menge an zu übertragenden Daten zur Beschreibung des Echosignalverlaufs zu minimieren. Die Signalverarbeitungseinheit jedes

Ultraschallsensors führt also sozusagen eine Datenkompression des Empfangssignals zur Erzeugung komprimierter Daten, nämlich der charakteristischen Echosignaldaten aus. Übertragen an das Rechnersystem werden dann die Informationen komprimiert. Hierdurch wird die EMV-Belastung durch die Datenübertragung minimiert und es können Statusdaten jedes

Ultraschallsensors zur Systemfehlererkennung in den zeitlichen Zwischenräumen an das Rechnersystem über den Datenbus zwischen Ultraschallsensor und Rechnersystem übertragen werden.

Es hat sich als vorteilhaft erwiesen, die Übertragung der Daten über den Datenbus zu priorisieren. Meldungen sicherheitskritischer Fehler jedes Sensors, also hier erfindungsgemäß jedes Ultraschallsensors, an das Rechnersystem haben dabei die höchste Priorität, da diese die Gültigkeit der Messdaten des Ultraschallsensors mit hoher Wahrscheinlichkeit beeinträchtigen. Diese Daten werden vom Ultraschallsystem an das Rechnersystem gesendet. Die zweithöchste Priorität haben Anfragen des Rechnersystems zur Durchführung sicherheitsrelevanter Selbsttests. Solche Befehle werden vom Rechnersystem an das Ultraschallsystem gesendet. Die dritthöchste Priorität haben die Daten des Ultraschallsensors selbst, da die Latenzzeit nicht erhöht werden darf. Alle anderen Daten haben für die Übertragung über den Datenbus niedrigere Prioritäten.

Es ist besonders vorteilhaft, wenn das Verfahren zur Übertragung von Sensordaten, insbesondere eines Ultraschallsensors, von einem Sensor zu einem Rechnersystem, insbesondere in einem Fahrzeug (umfassend das Aussenden eines Ultraschall-Bursts mit einem Anfang 57 und Ende 56 des Aussendens des Ultraschall-Bursts und umfassend das Empfangen eines Ultraschallsignals und bilden eines Empfangssignals für eine Empfangszeit T_{E} zumindest ab dem Ende 56 des Aussendens des Ultraschall-Bursts sowie umfassend das Übertragen der komprimierten Daten über einen Datenbus, insbesondere einen Eindrahtdatenbus, an das Rechnersystem) so gestaltet wird, dass die Übertragung 54 der Daten vom Sensor an das Rechnersystem mit einem Startbefehl 53 von dem Rechnersystem an den Sensor über den Datenbus und vor dem Ende 56 des Aussendens des Ultraschall-Bursts beginnt oder nach einem Startbefehl 53 von dem Rechnersystem an den Sensor über den Datenbus und vor dem Anfang 57 des Aussendens des Ultraschall-Bursts beginnt. Die Übertragung 54 erfolgt dann nach dem Startbefehl 53 periodisch fortlaufend bis zu einem Ende der Datenübertragung 58. Dieses Ende der Datenübertragung 58 liegt dann zeitlich nach dem Ende der Empfangszeit T_{E}.

Eine weitere Variante des vorgeschlagenen Verfahrens sieht als ersten Schritt der Datenkompression das Bilden eines Feature-Vektor-Signals aus dem Empfangssignal vor. Ein solches Feature-Vektor-Signal kann mehrere analoge und digitale Datensignale umfassen. Es stellt also eine mehr oder weniger komplexe Daten/Signal-Struktur dar. Im einfachsten Fall kann es als vektorielles Signal bestehend aus mehreren Teilsignalen aufgefasst werden.

Beispielsweise kann es sinnvoll sein, eine erste und/oder höhere zeitliche Ableitung des Empfangssignals oder das einfache oder mehrfache Integral des Empfangssignals zu bilden, die dann Teilsignale innerhalb des Feature-Vektor-Signals sind.

Es kann auch ein Hüllkurvensignal gebildet werden, das dann ein Teilsignal innerhalb des Feature-Vektor-Signals ist.

Des Weiteren kann es sinnvoll sein, das Empfangssignal mit dem ausgesendeten Ultraschallsignal zu falten und so ein Korrelationssignal zu bilden, das dann ein Teilsignal innerhalb des Feature-Vektor-Signals sein kann. Dabei kann zum einen das Signal als ausgesendetes Ultraschallsignal verwendet werden, das zur Ansteuerung des Treibers für den Sender verwendet wurde oder zum anderen beispielsweise ein Signal, dass am Sender gemessen wurde und so der tatsächlich abgestrahlten Schallwelle besser entspricht.

Schließlich kann es sinnvoll sein, durch Optimalfilter (Englisch matched filter) das Auftreten vorbestimmter Signalverlaufscharakteristika zu detektieren und ein Optimalfiltersignal für das jeweilige Signalverlaufscharakteristika einiger der vorbestimmten Signalverlaufscharakteristika zu bilden. Unter Optimalfilter versteht man hierbei ein Filter, welches das Signal-Rausch-Verhältnis (Englisch signal to noise ratio, SNR) optimiert. In dem gestörten Echosignal sollen vordefinierte Signalverlaufscharakteristika erkannt werden. In der Literatur findet man auch häufig die Bezeichnungen "Korrelationsfilter", "signalangepasstes Filter (SAF)" oder nur "angepasstes Filter". Das Optimalfilter dient zur optimalen Bestimmung des Vorhandenseins (Detektion) der Amplitude und/oder der Lage einer bekannten Signalform, des vorbestimmten Signalverlaufscharakteristika, und zwar auch in Gegenwart von Störungen (Parameterschätzung) beispielsweise von Signalen anderer Ultraschallsender und/oder bei Bodenechos.

Die Optimalfiltersignale sind dann bevorzugt Teilsignale innerhalb des Feature-Vektor-Signals.

Bestimmte Ereignisse können in gesonderten Teilsignalen des Feature-Vektor-Signals signalisiert werden. Diese Ereignisse sind auch Signalverlaufscharakteristika im Sinne dieser Erfindung. Signalverlaufscharakteristika umfassen also nicht nur besondere Signalformen, wie beispielsweise Rechteck-Pulse oder Wavelets oder Wellenzüge, sondern auch markante Punkte im Verlauf des Empfangssignals und/oder im Verlauf von daraus abgeleiteten Signalen, wie beispielsweise einem Hüllkurvensignal, das beispielsweise durch Filterung aus dem Empfangssignal gewonnen werden kann.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben ersten Schwellwert kreuzt.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben zweiten Schwellwert, der mit dem ersten Schwellwert identisch sein kann aufsteigend kreuzt.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben dritten Schwellwert, der mit dem ersten Schwellwert identisch sein kann abfallend kreuzt.

Ein anderes Signal, das ein Teilsignal des Feature-Vektor-Signals sein kann, kann beispielsweise detektieren, ob die Hüllkurve des Empfangssignals, das Hüllkurvensignal, ein Maximum oberhalb eines vierten Schwellwerts, der mit den vorgenannten Schwellwerten identisch sein kann, aufweist.

Ein anderes Signal, das ein Teilsignal des Feature-Vektor-Signals sein kann, kann beispielsweise detektieren, ob die Hüllkurve des Empfangssignals, das Hüllkurvensignal, ein Minimum oberhalb eines fünften Schwellwerts, der mit den vorgenannten Schwellwerten identisch sein kann, aufweist. Dabei wird bevorzugt ausgewertet, ob das zumindest eine vorausgehende Maximum der Hüllkurve einen Mindestabstand zu dem Minimum hat, um eine Detektion von Rauschen zu vermeiden. Andere Filterungen sind an dieser Stelle denkbar. Auch kann geprüft werden, ob der zeitliche Abstand zwischen diesem Minimum und einem vorausgehenden Maximum größer ist, als ein erster zeitlicher Mindestabstand. Die Erfüllung dieser Bedingungen setzt jeweils ein Flag oder Signal, das selbst wieder bevorzugt ein Teilsignal des Feature-Vektor-Signals ist.

Ebenso sollte in analoger Weise überprüft werden, ob die zeitlichen und amplitudenmäßigen Abstände der anderen Signalverlaufscharakteristika gewissen Plausibilitätsanforderungen, wie zeitliche Mindestabstände und/oder Mindestabstände in der Amplitude genügen. Auch aus diesen Prüfungen können sich weitere, auch analoge, binäre oder digitale Teilsignale abgeleitet werden, die somit das Feature-Vektor-Signal in seiner Dimensionalität weiter vergrößern.

Gegebenenfalls kann in einer Signifikanzsteigerungsstufe das Feature-Vektor-Signal zu einem signifikanten Feature-Vektor-Signal noch transformiert werden. In der Praxis hat sich aber gezeigt, dass dies zumindest für die heutigen Anforderungen noch nicht nötig ist.

Gemäß einer Variante des erfindungsgemäßen Verfahrens folgt das Erkennen und das Klassifizieren von Signalverlaufscharakteristika in erkannte Signalverlaufscharakteristikum-Klassen innerhalb des Empfangssignals auf Basis des Feature-Vektor-Signals oder des signifikanten Feature-Vektor-Signals.

Liegt beispielsweise die Amplitude des Ausgangssignals eines Optimalfilters, und damit eines Teilsignals des Feature-Vektor-Signals oberhalb eines gegebenenfalls optimalfilterspezifischen sechsten Schwellwerts, so kann das Signalverlaufscharakteristika, für das der Optimalfilter ausgelegt ist, als erkannt gelten. Dabei werden vorzugsweise auch andere Parameter berücksichtigt. Wurde beispielsweise ein Ultraschall-Burst mit ansteigender Frequenz während des Bursts gesendet (genannt Chirp-Up), so wird auch ein Echo erwartet, dass diese Modulationseigenschaft aufweist. Stimmt die Signalform der Hüllkurve, beispielsweise eine dreieckige Signalform der Hüllkurve, zeitlich lokal mit einer erwarteten Signalform überein, aber nicht jedoch die Modulationseigenschaft, so handelt es sich eben nicht um ein Echo des Senders, sondern um ein Störsignal, das von anderen Ultraschallsendern herrühren kann oder aus Überreichweiten. Insofern kann das System dann zwischen Eigenechos und Fremdechos unterscheiden, wodurch ein und dieselbe Signalform zwei unterschiedlichen Signalverlaufscharakteristika, nämlich Eigenechos und Fremdechos, zugeordnet wird. Die Übertragung der Eigenechos erfolgt dabei vorzugsweise priorisiert gegenüber der Übertragung der Fremdechos, da erstere in der Regel sicherheitsrelevant sind und zweite in der Regel nicht sicherheitsrelevant sind.

Typischerweise wird jedem erkannten Signalverlaufscharakteristikum zumindest ein Signalverlaufscharakteristikum-Parameter zugeordnet oder für dieses Signalverlaufscharakteristikum bestimmt. Hierbei handelt es sich bevorzugt um einen Zeitstempel, der angibt, wann im Echosignal das Charakteristikum aufgetreten ist. Dabei kann der Zeitstempel sich beispielsweise auf den zeitlichen Beginn des Signalverlaufscharakteristikums im Empfangssignal oder das zeitliche Ende oder die zeitliche Lage des zeitlichen Schwerpunkts des Signalverlaufscharakteristikums etc. beziehen. Auch sind andere Signalverlaufscharakteristikum-Parameter, wie Amplitude, Streckung etc. denkbar. In einer Variante des vorgeschlagenen Verfahrens wird somit zumindest einer der zugeordneten Signalverlaufscharakteristikum-Parameter mit der zumindest einen erkannten Klasse von Signalverlaufscharakteristika übertragen, der ein Zeitwert ist und der eine zeitliche Position angibt, die geeignet ist, daraus auf die Zeit seit Aussendung eines vorausgegangenen Ultraschall-Bursts schließen zu können. Vorzugsweise erfolgt daraus später die Ermittlung eines ermittelten Abstands eines Objekts (z.B. Hindernisses) um Umfeld des Fahrzeugs in Abhängigkeit von einem dermaßen ermittelten und übertragenen Zeitwert.

Es folgt schließlich das priorisierte Übertragen der erkannten Signalverlaufscharakteristikum-Klassen vorzugsweise jeweils zusammen mit den zugeordneten Signalverlaufscharakteristikum-Parametern. Die Übertragung kann auch in komplexeren Datenstrukturen erfolgen. Beispielsweise ist es denkbar, zuerst die Zeitpunkte der erkannten sicherheitsrelevanten Signalverlaufscharakteristika (z.B. identifizierte Hindernisse) zu übertragen und dann die erkannten Signalverlaufscharakteristikum-Klassen der sicherheitsrelevanten Signalobjekte. Hierdurch wird die Latenzzeit weiter verringert.

Gemäß einer Variante des erfindungsgemäßen Verfahrens umfasst dieses das Ermitteln eines Chirp-Werts als zugeordneten Signalverlaufscharakteristikum-Parameter, der angibt, ob es sich bei dem erkannten Signalverlaufscharakteristikum um ein Echo eines Ultraschall-Sende-Bursts mit Chirp-Up oder ein Chirp-Down oder ein No-Chirp-Eigenschaften handelt. "Chirp-Up" bedeutet, dass die Frequenz innerhalb des empfangenen Signalverlaufscharakteristikums im Empfangssignal ansteigt. "Chirp-Down" bedeutet, dass die Frequenz innerhalb des empfangenen Signalverlaufscharakteristikums im Empfangssignal abfällt. "No-Chirp" bedeutet, dass die Frequenz innerhalb des empfangenen Signalverlaufscharakteristikums im Empfangssignal im Wesentlichen gleichbleibt.

Gemäß einer Variante des erfindungsgemäßen Verfahrens kann auch ein Confidence-Signal (Konfidenzwert) durch z.B. Bildung der Korrelation zwischen dem Empfangssignal oder einem daraus abgeleiteten Signal einerseits und einem Referenzsignal, beispielsweise dem Ultraschallsendesignal oder einem anderen erwarteten Wavelet gebildet werden. Das Confidence-Signal ist dann typischerweise ein Teilsignal des Feature-Vektor-Signals.

In einer anderen Variante des Verfahrens wird auf dieser Basis auch ein Phasen-Signal gebildet, das die Phasenverschiebung beispielsweise des Empfangssignals oder eines daraus gebildeten Signals (z.B. des Confidence-Signals) gegenüber einem Referenzsignal, beispielsweise dem Ultraschallsendesignal und/oder einem anderen Referenzsignal angibt.

In ähnlicher Weise kann in einer weiteren Variante des vorgeschlagenen Verfahrens ein Phasen-Confidence-Signal durch Bildung der Korrelation zwischen dem Phasen-Signal oder einem daraus abgeleiteten Signal einerseits und einem Referenzsignal gebildet werden und als Teilsignal des Feature-Vektor-Signals verwendet werden.

Bei der Auswertung des Feature-Vektor-Signals ist es dann sinnvoll einen Vergleich des Phasen-Confidence-Signals mit einem oder mehreren Schwellwerten zur Erzeugung eines diskretisierten Phasen-Confidence-Signals durchzuführen, das selbst wieder Teil des Feature-Vektor-Signals werden kann.

Die Auswertung des Feature-Vektor-Signals und/oder des signifikanten Feature-Vektor-Signals kann in einer Variante des vorgeschlagenen Verfahrens so erfolgen, dass ein oder mehrere Abstandswerte zwischen dem Feature-Vektor-Signal und einem oder mehreren Signalverlaufscharakteristikum-Prototypenwerten für erkennbare Signalverlaufscharakteristikum-Klassen gebildet werden. Ein solcher Abstandswert kann boolsch, binär, diskret, digital oder analog sein. Vorzugsweise werden alle Abstandswerte in einer nichtlinearen Funktion miteinander verknüpft. So kann bei einem erwarteten Chirp-Up-Echo in Dreiecksform ein empfangenes Chirp-Down-Echo in Dreiecksform verworfen werden. Dieses Verwerfen ist ein nichtlinearer Vorgang.

Umgekehrt kann das Dreieck im Empfangssignal unterschiedlich ausgeprägt sein. Dies betrifft zuallererst die Amplitude des Dreiecks im Empfangssignal. Ist die Amplitude im Empfangssignal hinreichend, so liefert beispielsweise das diesem Dreiecksignal zugeordnete Optimalfilter ein Signal oberhalb eines vorgegeben siebten Schwellwerts. In dem Fall kann dann beispielsweise diese Signalverlaufscharakteristikum-Klasse (Dreiecksignal) erkanntes Signalverlaufscharakteristikum diesem Zeitpunkt des Überschreitens zugeordnet werden. In dem Fall unterschreitet der Abstandswert zwischen dem Feature-Vektor-Signal und dem Prototyp (hier der siebte Schwellwert) einen oder mehrere vorbestimmte, binäre, digitale oder analoge Abstandswerte (hier 0= Kreuzung).

Bei einer weiteren Variante des Verfahrens handelt es sich bei mindestens einer Signalverlaufscharakteristikum-Klasse um Wavelets, die durch Schätzvorrichtungen (z.B. Optimalfilter) und/oder Schätzverfahren (z.B. Schätzprogramme, die in einem digitalen Signalprozessor ablaufen) geschätzt und damit detektiert werden. Mit dem Begriff Wavelet werden Funktionen bezeichnet, die einer kontinuierlichen oder diskreten Wavelet-Transformation zugrunde gelegt werden können. Das Wort ist eine Neuschöpfung aus dem französischen "ondelette", das "kleine Welle" bedeutet und teils wörtlich ("onde" -> "wave"), teils phonetisch ("-lette" -> "-let") ins Englische übertragen wurde. Der Ausdruck "Wavelet" wurde in den 1980er Jahren in der Geophysik (Jean Morlet, Alex Grossmann) für Funktionen geprägt, welche die Kurzzeit-Fourier-Transformation verallgemeinern, wird jedoch seit Ende der 1980er Jahre ausschließlich in der heute üblichen Bedeutung verwendet. In den 1990er Jahren entstand ein regelrechter Wavelet-Boom, ausgelöst durch die Entdeckung von kompakten, stetigen (bis hin zu beliebiger Ordnung der Differenzierbarkeit) und orthogonalen Wavelets durch Ingrid Daubechies (1988) und die Entwicklung des Algorithmus der schnellen Wavelet-Transformation (FWT) mit Hilfe der Multiskalenanalyse (MultiResolution Analysis - MRA) durch Stéphane Mallat und Yves Meyer (1989).

Im Gegensatz zu den Sinus- und Kosinus-Funktionen der Fourier-Transformation besitzen die meistverwendeten Wavelets nicht nur Lokalität im Frequenzspektrum, sondern auch im Zeitbereich. Dabei ist "Lokalität" im Sinne kleiner Streuung zu verstehen. Die Wahrscheinlichkeitsdichte ist das normierte Betragsquadrat der betrachteten Funktion bzw. von deren Fourier-Transformierten. Dabei ist das Produkt beider Varianzen immer größer als eine Konstante, analog zur Heisenbergschen Unschärferelation. Aus dieser Einschränkung heraus entstanden in der Funktionalanalysis die Paley-Wiener-Theorie (Raymond Paley, Norbert Wiener), ein Vorläufer der diskreten Wavelet-Transformation, und die Calderón-Zygmund-Theorie (Alberto Calderón, Antoni Zygmund), die der kontinuierlichen Wavelet-Transformation entspricht.

Das Integral einer Wavelet-Funktion ist im Fachgebrauch zwar immer 0, daher nimmt in der Regel die Waveletfunktion die Form von nach außen hin auslaufenden (kleiner werdenden) Wellen (also 2Wellchen" = Ondelettes = Wavelets) an. Im Sinne dieser Erfindung sollen aber auch Wavelets zulässig sein, die ein von 0 verschiedenes Integral besitzen. Hier sei beispielhaft die im Folgenden beschriebenen Rechteck und Dreiecks-Wavelets genannt.

Wichtige Beispiele für Wavelets mit 0-Integral sind das Haar-Wavelet (Alfréd Haar 1909), die nach Ingrid Daubechies benannten Daubechies-Wavelets (um 1990), die ebenfalls von ihr konstruierten Coiflet-Wavelets und das eher theoretisch bedeutsame Meyer-Wavelet (Yves Meyer, um 1988).

Wavelets gibt es für Räume beliebiger Dimension, meist wird ein Tensorprodukt einer eindimensionalen Waveletbasis verwendet. Aufgrund der fraktalen Natur der Zwei-Skalen-Gleichung in der MRA haben die meisten Wavelets eine komplizierte Gestalt, die meisten haben keine geschlossene Form. Dies ist deswegen von besonderer Bedeutung, da das zuvor erwähnte Feature-Vektor-Signal ja mehrdimensional ist und daher die Verwendung multidimensionaler Wavelets zur Signalobjekterkennung zulässt.

Eine besondere Variante des vorgeschlagenen Verfahrens ist daher die Verwendung multidimensionale Wavelets mit mehr als zwei Dimensionen zur Signalobjekterkennung. Insbesondere wird die Verwendung entsprechender Optimalfilter zur Erkennung solcher Wavelets mit mehr als zwei Dimensionen vorgeschlagen, um das Feature-Vektor Signal um weitere zur Erkennung geeignete Teilsignale gegebenenfalls zu ergänzen.

Ein besonders geeignetes Wavelet, insbesondere zur Analyse des Hüllkurvensignals, ist beispielsweise ein Dreiecks-Wavelet. Dieses zeichnet sich durch einen Startzeitpunkt des Dreiecks-Wavelets, einen dem Startzeitpunkt des Dreiecks-Wavelets zeitlich nachfolgenden zeitlich linearen Anstieg der Wavelet-Amplitude bis zu einem Maximum der Amplitude des Dreiecks-Wavelets und einen dem Maximum des Dreiecks-Wavelets zeitlich nachfolgenden zeitlich linearen Abfall der Wavelet-Amplitude bis zu einem Ende des Dreiecks-Wavelets aus.

Ein weiteres besonders geeignetes Wavelet ist ein Rechteck-Wavelet, das im Sinne dieser Erfindung auch trapezförmige Wavelets miteinschließt. Ein Rechteck-Wavelet zeichnet sich durch einen Startzeitpunkt des Rechteck-Wavelets aus, dem ein Anstieg der Wavelet-Amplitude des Rechteck-Wavelets mit einer ersten zeitlichen Steilheit des Rechteck-Wavelets bis zu einem ersten Plateau-Zeitpunkt des Rechteck-Wavelets folgt. Dem ersten Plateau-Zeitpunkt des Rechteck-Wavelets folgt ein Verharren der Wavelet-Amplitude mit einer zweiten Steilheit der Wavelet-Amplitude bis zu einem zweiten Plateau-Zeitpunkt des Rechteck-Wavelets. Dem zweiten Plateau-Zeitpunkt des Rechteck-Wavelets folgt ein Abfall mit einer dritten zeitlichen Steilheit bis zum zeitlichen Ende des Rechteck-Wavelets. Dabei beträgt der Betrag der zweiten zeitlichen Steilheit weniger als 10% des Betrags der ersten zeitlichen Steilheit und weniger als 10% des Betrags der dritten zeitlichen Steilheit.

Statt der zuvor beschriebenen Wavelets ist auch die Verwendung anderer zweidimensionaler Wavelets, wie beispielsweise ein Sinushalbwellen-Wavelets möglich, das ebenfalls ein Integral ungleich 0 aufweist.

Es wird vorgeschlagen, dass bei Verwendung von Wavelets die zeitliche Verschiebung des betreffenden Wavelets des erkannten Signalverlaufscharakteristikums als ein Signalverlaufscharakteristikum-Parameter beispielsweise durch Korrelation und/oder dem Zeitpunkt der Überschreitung des Pegels des Ausgangs eines zur Detektion des betreffenden Wavelets geeigneten Optimalfilters über einen vordefinierten Schwellwert für dieses Signalverlaufscharakteristikum bzw. dieses Wavelet. Vorzugsweise werden die Hüllkurve des Empfangssignals und/oder ein Phasensignal und/oder ein Confidence-Signal etc. ausgewertet.

Ein weiterer möglicher Signalverlaufscharakteristikum-Parameter, der ermittelt werden kann, ist eine zeitliche Kompression oder Dehnung des betreffenden Wavelets des erkannten Signalverlaufscharakteristikums. Ebenso kann eine Amplitude des Wavelets des erkannten Signalverlaufscharakteristikums ermittelt werden.

Es wurde bei der Ausarbeitung des Vorschlags für das hier offenbarte Verfahren erkannt, dass es vorteilhaft ist, die Daten der erkannten Signalverlaufscharakteristika der sehr schnell eintreffenden Echos zuerst vom Sensor zum Rechnersystem zu übertragen und dann erst die nachfolgenden Daten der später erkannten Signalverlaufscharakteristika. Vorzugsweise wird dabei immer zumindest die erkannte Signalverlaufscharakteristikum-Klasse und ein Zeitstempel übertragen, der vorzugsweise angeben sollte, wann das Signalverlaufscharakteristikum beim Sensor wieder eingetroffen ist. Im Rahmen des Erkennungsprozesses können den verschiedenen Signalverlaufscharakteristika, die für einen Abschnitt des Empfangssignals in Frage kommen, Scores zugeordnet werden, die angeben, welche Wahrscheinlichkeit entsprechend dem verwendeten Schätzalgorithmus dem Vorliegen dieses Signalverlaufscharakteristikums zugeordnet wird. Ein solcher Score ist im einfachsten Fall binär. Vorzugsweise handelt es sich jedoch um eine komplexe, reelle oder Integer-Zahl. Sofern mehrere Signalverlaufscharakteristika einen hohen Score-Wert haben, ist es in manchen Fällen sinnvoll, auch die Daten erkannter Signalverlaufscharakteristika mit niedrigeren Score-Werten zu übertragen. Um dem

Rechnersystem die richtige Handhabung zu ermöglichen sollten für diesen Fall nicht nur das Datum des erkannten Signalverlaufscharakteristikums und der Zeitstempel für das jeweilige Signalverlaufscharakteristikum übertragen werden, sondern auch der ermittelte Score-Wert. Somit wird in diesem Fall eine Hypothesenliste aus erkannten Signalverlaufscharakteristika und deren zeitlichen Positionen sowie zusätzlich zugeordneten Score-Werten an das Rechnersystem übertragen.

Vorzugsweise erfolgt die Übertragung der Daten der erkannten Signalverlaufscharakteristikum-Klasse und er zugeordneten Daten wie beispielsweise Zeitstemple und Score-Werte der jeweiligen erkannten Signalverlaufscharakteristikum-Klassen, also der zugeordneten Signalverlaufscharakteristikum-Parameter, nach dem FIFO-Prinzip. Dies stellt sicher, dass stets die Daten der Reflektionen der am nächsten liegenden Objekte zuerst übertragen werden und so der sicherheitskritische Fall des Zusammenstoßes des Fahrzeugs mit einem Hindernis priorisiert nach Wahrscheinlichkeit bearbeitet wird.

Neben der Übertragung von Messdaten kann auch die Übertragung von Fehlerzuständen des Sensors erfolgen. Dies kann auch während einer Empfangszeit T_{E} geschehen, wenn der Sensor durch Selbsttestvorrichtungen feststellt, dass ein Defekt vorliegt und die zuvor übertragenen Daten potenziell fehlerhaft sein könnten. Somit wird sichergestellt, dass das Rechnersystem zum frühestmöglichen Zeitpunkt über eine Änderung der Bewertung der Messdaten Kenntnis erlangen kann und diese verwerfen oder anders behandeln kann. Dies ist von besonderer Bedeutung für Notbremssysteme, da eine Notbremsung ein sicherheitskritischer Eingriff ist, der nur dann eingeleitet werden darf, wenn die zugrundeliegenden Daten einen entsprechenden Vertrauenswert besitzen. Dem gegenüber wird daher die Übertragung der Messdaten, also beispielsweise des Datums der erkannten Signalverlaufscharakteristikum-Klasse und/oder die Übertragung des einen zugeordneten Signalverlaufscharakteristikum-Parameters zurückgestellt und damit niedriger priorisiert. Natürlich ist ein Abbruch der Übertragung bei Auftreten eines Fehlers im Sensor denkbar. In manchen Fällen kann es aber vorkommen, dass ein Fehler möglich erscheint, aber nicht sicher vorliegt. Insofern ist in solchen Fällen die Fortsetzung einer Übertragung angezeigt. Die Übertragung sicherheitskritischer Fehler des Sensors erfolgt somit vorzugsweise höher priorisiert.

Neben den bereits beschriebenen Wavelets mit einem Integrationswert von 0 und den zusätzlich hier als Wavelet bezeichneten Signalabschnitten mit einem Integrationswert verschieden von 0 können auch bestimmte Zeitpunkt im Verlauf des Empfangssignals als Signalverlaufscharakteristikum im Sinne dieser Erfindung aufgefasst werden, die zu einer Datenkompression verwendet werden können und anstelle von Abtastwerten des Empfangssignals übertragen werden können. Diese Untermenge in der Menge möglicher Signalverlaufscharakteristika bezeichnen wir im Folgenden als Signalzeitpunkte. Die Signalzeitpunkte sind also im Sinne dieser Erfindung eine spezielle Form der Signalverlaufscharakteristika.

Ein erster möglicher Signalzeitpunkt und damit ein Signalverlaufscharakteristikum ist ein Kreuzen der Amplitude des Hüllkurvensignals 1 mit der Amplitude eines Schwellwertsignals SW in aufsteigender Richtung.

Ein zweiter möglicher Signalzeitpunkt und damit ein Signalverlaufscharakteristikum ist ein Kreuzen der Amplitude des Hüllkurvensignals 1 mit der Amplitude eines Schwellwertsignals SW in absteigender Richtung.

Ein dritter möglicher Signalzeitpunkt und damit ein Signalverlaufscharakteristikum ist ein Maximum der Amplitude des Hüllkurvensignals 1 oberhalb der Amplitude eines Schwellwertsignals SW.

Ein vierter möglicher Signalzeitpunkt und damit ein Signalverlaufscharakteristikum ist ein Minimum der Amplitude des Hüllkurvensignals 1 oberhalb der Amplitude eines Schwellwertsignals SW.

Gegebenenfalls kann es sinnvoll sein, für diese vier beispielhaften Typen von Signalzeitpunkten und weitere Typen von Signalzeitpunkten signalzeitpunkttypspezifische Schwellwertsignale zu verwenden.

Die zeitliche Abfolge von Signalverlaufscharakteristika ist typischerweise nicht beliebig. Wird beispielsweise ein Dreiecks-Wavelet im Hüllkurvensignal 1 ausreichender Amplitude erwartet, so kann zusätzlich zu einem entsprechenden Mindestpegel am Ausgang eines für die Detektion eines solchen Dreiecks-Wavelets geeigneten Optimal-Filters
1. das Auftreten eines ersten möglichen Signalzeitpunkts mit einem Kreuzen der Amplitude des Hüllkurvensignals 1 mit der Amplitude eines Schwellwertsignals SW in aufsteigender Richtung und daran zeitlich anschließend
2. das Auftreten eines dritten möglichen Signalzeitpunkts mit einem Maximum der Amplitude des Hüllkurvensignals 1 oberhalb der Amplitude eines Schwellwertsignals SW und daran zeitlich anschließend
3. das Auftreten eines zweiten möglichen Signalzeitpunkts mit einem Kreuzen der Amplitude des Hüllkurvensignals 1 mit der Amplitude eines Schwellwertsignals SW in absteigender Richtung
in zeitlicher Korrelation zum Überschreiten des besagten Mindestpegels am Ausgang des besagten Optimalfilters erwartet werden. Dieses Überschreiten des besagten Mindestpegels am Ausgang des besagten Optimalfilters ist übrigens ein weiteres Beispiel für einen fünften möglichen Signalzeitpunkt und damit ein weiteres mögliches Signalverlaufscharakteristikum.

Die sich somit ergebende Gruppierung und zeitliche Abfolge von erkannten Signalverlaufscharakteristika kann selbst, beispielsweise durch einen Viterbi-Decoder, als eine vordefinierte, erwartete Gruppierung oder zeitliche Abfolge von Signalverlaufscharakteristika erkannt werden und kann somit selbst wieder ein Signalverlaufscharakteristikum darstellen. Somit ist ein sechster möglicher Signalzeitpunkt und damit ein Signalverlaufscharakteristikum eine solche vordefinierte Gruppierung und/oder zeitliche Abfolge von anderen Signalverlaufscharakteristika.

Wird eine solche Gruppierung von Signalverlaufscharakteristika oder zeitliche Abfolge solcher Signalverlaufscharakteristikum-Klassen erkannt, so folgt das Übertragen der dieser erkannten zusammenfassenden Signalverlaufscharakteristikum-Klasse und zumindest des einen zugeordneten Signalverlaufscharakteristikum-Parameters vorzugsweise an Stelle der Übertragung der einzelnen Signalverlaufscharakteristika, da hierdurch erhebliche Datenbuskapazität gespart wird. Es mag Fälle geben, in denen beides übertragen wird. Hierbei wird das Datum der Signalverlaufscharakteristikum-Klasse eines Signalverlaufscharakteristikums übertragen, das eine vordefinierte zeitliche Abfolge und/oder Gruppierung von anderen Signalverlaufscharakteristika ist. Um eine Kompression zu erreichen ist es vorteilhaft, wenn zumindest eine Signalverlaufscharakteristikum-Klasse zumindest eines dieser anderen Signalverlaufscharakteristika nicht übertragen wird.

Eine zeitliche Gruppierung von Signalverlaufscharakteristika liegt insbesondere dann vor, wenn der zeitliche Abstand dieser Signalverlaufscharakteristika einen vordefinierten Abstand nicht überschreitet. Im zuvor erwähnten Beispiel sollte die Laufzeit des Signals im Optimalfilter bedacht werden. Typischerweise dürfte das Optimalfilter langsamer als die Komparatoren sein. Daher sollte der Wechsel im Ausgangssignal des Optimalfilters in einem festen zeitlichen Zusammenhang zu dem zeitlichen Auftreten der relevanten Signalzeitpunkte stehen.

Besonders bevorzugt erfolgt die Datenübertragung im Fahrzeug über einen bidirektionalen Eindraht-Datenbus. Die Rückleitung wird hierbei bevorzugt durch die Karosserie des Fahrzeugs sichergestellt. Vorzugsweise werden die Sensordaten strommoduliert an das Rechnersystem gesendet. Die Daten zur Steuerung des Sensors werden durch das Rechnersystem vorzugsweise spannungsmoduliert an den Sensor gesendet. Erfindungsgemäß wurde erkannt, dass die Verwendung eines PSI5-Datenbusses und/oder eines DSI3-Datenbusses für die Datenübertragung besonders geeignet ist. Des Weiteren wurde erkannt, dass es besonders vorteilhaft ist, die Übertragung der Daten an das Rechnersystem mit einer Übertragungsrate von > 200 kBit/s und vom Rechnersystem zu dem mindestens einen Sensor mit einer Übertragungsrate > 10 kBit/s, vorzugsweise 20 kBit/s vorzunehmen. Des Weiteren wurde erkannt, dass die Übertragung von Daten von dem Sensor an das Rechnersystem mit einem Sendestrom auf den Datenbus moduliert werden sollte, dessen Stromstärke weniger als 50 mA, bevorzugt weniger als 5 mA, bevorzugt weniger al 2,5 mA betragen sollte. Für diese Betriebswerte müssen diese Busse entsprechend angepasst werden. Das Grundprinzip bleibt aber bestehen.

Für die Durchführung der zuvor beschriebenen Verfahren wird ein Rechnersystem mit einer Datenschnittstelle zu dem besagten Datenbus, vorzugsweise dem besagten Eindrahtdatenbus, benötigt, dass die Dekompression der dermaßen komprimierten Daten unterstützt. In der Regel wird das Rechnersystem jedoch keine vollständige Dekompression vornehmen, sondern beispielsweise lediglich den Zeitstempel und den erkannten Signalverlaufscharakteristikum-Typ auswerten. Der Sensor, der zur Durchführung eines der zuvor beschrieben Verfahren benötigt wird, weist mindestens einen Sender und mindestens einen Empfänger zur Erzeugung eines Empfangssignals auf, die auch als ein oder mehrere Transducer kombiniert vorliegen können. Des Weiteren weist er zumindest Vorrichtungen zur Verarbeitung und Kompression des Empfangssignals auf sowie eine Datenschnittstelle zur Übertragung der Daten über den Datenbus, vorzugsweise den besagten Eindrahtdatenbus, an das Rechnersystem auf. Für die Kompression weist die Vorrichtung zur Kompression vorzugsweise zumindest eines der folgenden Teilvorrichtungen auf: Optimalfilter, Komparatoren, Schwellwertsignalerzeugungsvorrichtungen zur Erzeugung eines oder mehrerer Schwellwertsignale SW, Komparatoren, Differenzierer zur Bildung von Ableitungen, Integrierer zur Bildung integrierter Signale, sonstige Filter, Hüllkurvenformer zur Erzeugung eines Hüllkurvensignals aus dem Empfangssignal, Korrelationsfilter zum Vergleich des Empfangssignals oder von daraus abgeleiteten Signalen mit Referenzsignalen.

Die Erfindung wird nachfolgend anhand von Ausführungsbeispielen und unter Bezugnahme auf die Zeichnung näher erläutert. Im Einzelnen zeigen dabei:
- Fig. 1: den prinzipiellen Ablauf der Signalkompression und der Übertragung,
- Fig. 2: detaillierter den prinzipiellen Ablauf der Signalkompression und der Übertragung,
- Fig. 3a: ein herkömmliches Ultraschall-Echo-Signal und dessen konventionelle Auswertung,
- Fig. 3b: ein herkömmliches Ultraschall-Echo-Signal und dessen Auswertung, wobei die Amplitude mitübertragen wird,
- Fig. 3c: ein Ultraschall-Echo-Signal, wobei die Chirp-Richtung enthalten ist,
- Fig. 3d: erkannte Signalobjekte (Dreiecksignale) in dem Signal der Fig. 3c unter Verwurf nicht erkannter Signalanteile,
- Fig. 4a: die nicht beanspruchte konventionelle Übertragung,
- Fig. 4b: die nicht beanspruchte Übertragung analysierter Daten nach vollständigem Empfang des Ultraschallechos,
- Fig. 4c: die beanspruchte Übertragung komprimierter Daten, wobei in diesem Beispiel Symbole für Signalgrundobjekte weitestgehend ohne Kompression entsprechend dem Stand der Technik,
- Fig. 5: die beanspruchte Übertragung komprimierter Daten, wobei in diesem Beispiel Symbole für Signalgrundobjekte zu Symbolen für Signalobjekte komprimiert werden,
- Fig. 6: die beanspruchte Übertragung komprimierter Daten, wobei in diesem Beispiel Symbole für Signalgrundobjekte zu Symbolen für Signalobjekte komprimiert werden und nicht nur das Hüllkurvensignal, sondern auch das Confidenz-Signal ausgewertet wird.

Wie oben erläutert, sind die technischen Lehren aus dem Stand der Technik allesamt von dem Gedanken geleitet, die Erkennung eines Objekts vor dem Fahrzeug mit Hilfe des Ultraschallsensors bereits im Ultraschallsensor durchzuführen und dann erst die Objektdaten nach Erkennung der Objekte zu übertragen. Da hierbei jedoch Synergieeffekte bei der Verwendung mehrerer Ultraschallsender verloren gehen, wurde im Rahmen der Erfindung erkannt, dass es nicht sinnvoll ist, nur die Echo-Daten des Ultraschallsensors selbst, sondern alle Daten zu übertragen.

In einem zentralen Rechnersystem können überdies mit Vorteil die Daten vorzugsweise mehrerer Sensoren gewertet werden. Hierfür muss die Kompression der Daten für die Übertragung über einen Datenbus mit geringerer Busbandbreite aber anders erfolgen als im Stand der Technik. Hierdurch können dann Synergieeffekte erschlossen werden. So ist es beispielsweise denkbar, dass ein Fahrzeug mehr als einen Ultraschallsensor aufweist. Um die beiden Sensoren unterscheiden zu können, ist es sinnvoll, wenn diese beiden Sensoren mit unterschiedlicher Codierung senden. Im Gegensatz zum Stand der Technik sollen beide Sensoren aber nun die Ultraschallechos beider Abstrahlungen beider Ultraschallsensoren erfassen und geeignet komprimiert an das zentrale Rechnersystem übertragen, wo die Ultraschallempfangssignale rekonstruiert und fusioniert werden. Erst nach der Rekonstruktion (Dekompression) erfolgt die Erkennung der Hindernisse (Objekte in der Umgebung). Dies ermöglicht zudem die weitere Fusion der Ultraschallsensordaten mit den Daten anderer Sensorsysteme wie z. B. Radar etc.

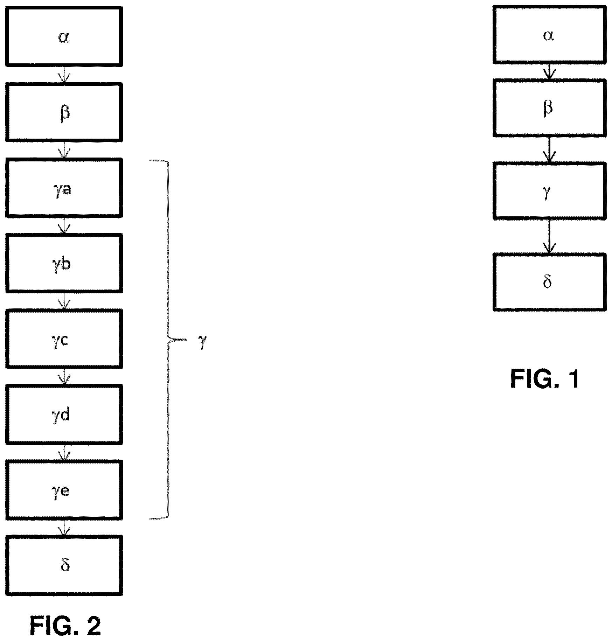

Mit der Erfindung wird ein Verfahren zur Übertragung von Sensordaten von mindestens zwei Sensoren zu einem Rechnersystem vorgeschlagen. Das erfindungsgemäße Verfahren ist für die Übertragung von Daten aus Ultraschallempfangssignalen von Ultraschallsensoren an ein Steuergerät als Rechnersystem in einem Fahrzeug geeignet. Das Verfahren wird anhand der Fig. 1 erläutert. Gemäß dem vorgeschlagenen Verfahren wird zunächst ein Ultraschall-Burst erzeugt und in einen Freiraum, typischerweise im Umfeld des Fahrzeugs ausgesendet (Schritt α der Fig. 1). Ein Ultraschall-Burst besteht dabei aus mehreren mit Ultraschallfrequenz aufeinander folgenden Schallpulsen. Dieser Ultraschall-Burst entsteht dadurch, dass ein mechanischer Schwinger in einem Ultraschallsender oder Ultraschall-Transducer langsam anschwingt und wieder ausschwingt. Der so von dem beispielhaften Ultraschall-Transducer ausgesendete Ultraschall-Burst wird dann an Objekten im Umfeld des Fahrzeugs reflektiert und durch einen Ultraschallempfänger oder den Ultraschall-Transducer selbst als Ultraschallsignal empfangen und in ein elektrisches Empfangssignal umgewandelt (Schritt β der Fig. 1). Besonders bevorzugt ist der Ultraschallsender identisch mit dem Ultraschallempfänger, was im Folgenden dann als Transducer bezeichnet wird, bei dem es sich um ein elektroakustisches Bauteil handelt, das wechselweise als Ultraschallsender und Ultraschallempfänger und damit als -sensor betrieben wird. Das im Folgenden erläuterte Prinzip lässt sich aber auch für getrennte Empfänger und Sender anwenden. In dem vorgeschlagenen Ultraschallsensor befindet sich eine Signalverarbeitungseinheit, die nun das dem Ultraschall-Empfangssignal entsprechende elektrische Empfangssignal (nachfolgend als "Empfangssignal" bezeichnet) analysiert und komprimiert (Schritt γ der Fig. 1), um die notwendige Datenübertragung (Menge an zu übertragenden Daten) zu minimieren und Freiraum für z. B. Statusmeldungen und weitere Steuerbefehle des Steuerrechners an die Signalverarbeitungseinheit bzw. das Ultraschallsensorsystem zu schaffen. Anschließend wird das komprimierte elektrische Empfangssignal an das Rechnersystem übertragen (Schritt δ der Fig. 1).

Das zugehörige Verfahren dient also dazu, die Daten von mindestens zwei Ultraschallsensoren an ein Rechnersystem in einem Fahrzeug zu übertragen. Vorgeschaltet sind das Aussenden eines Ultraschall-Bursts (Schritt α der Fig. 1) und das Empfangen eines Ultraschallsignals sowie das Bilden eines elektrischen Empfangssignals (Schritt β der Fig. 1). Danach erfolgt die Durchführung einer Datenkompression des Empfangssignals (Schritt γ der Fig. 1) zur Erzeugung komprimierter Daten (Schritt γ der Fig. 1) durch Erfassung von vorzugsweise mindestens zwei oder drei oder mehr vorbestimmten Eigenschaften im Empfangssignal. Bevorzugt wird das elektrische Empfangssignal durch Abtastung (Schritt ya der Fig. 2, in der der Schritt ya in z. B. fünf Teilschritte unterteilt ist) in ein abgetastetes Empfangssignal verwandelt, das aus einem zeitdiskreten Strom von Abtastwerten besteht. Jedem Abtastwert kann dabei typischerweise ein Abtastzeitpunkt als Zeitstempel dieses Abtastwertes zugeordnet werden. Die Kompression kann beispielsweise durch eine Wavelet-Transformation (Schritt yb der Fig. 2) erfolgen. Hierfür kann das empfangene Ultraschallsignal in Form des abgetasteten Empfangssignals mit vorbestimmten Signal-Grundformen (weiter oben als Signalcharakteristika bezeichnet), die beispielsweise in einer Bibliothek abgelegt sind, durch Bildung eines Korrelationsintegrals (siehe auch Wikipedia zu diesem Begriff) zwischen den vorbestimmten Signal-Grundformen und dem abgetasteten Empfangssignal verglichen werden. Die zeitliche Aufeinanderfolge von Signalgrundformen im Empfangssignal bildet jeweils ein Signalobjekt, das einer von mehreren Signalobjektklassen zugeordnet wird. Durch die Bildung des Korrelationsintegrals werden für jede dieser Signalobjektklassen jeweils zugehörige Spektralwerte dieser Signalobjektklasse ermittelt. Da dies fortlaufend geschieht, stellen die Spektralwerte selbst einen Strom von zeitdiskreten momentanen Spektralwerten dar, wobei jedem Spektralwert wieder ein Zeitstempel zugeordnet werden kann. Eine alternative, mathematisch äquivalente Methode ist die Verwendung von Optimalfiltern (englisch matched-filter) je vorbestimmter Signalobjektklasse (Signal-Grundform). Da in der Regel mehrere Signalobjektklassen verwendet werden, die zudem noch unterschiedlichen zeitlichen Spreizungen unterworfen werden können (siehe auch "Wavelet-Analyse"), ergibt sich auf diese Weise typischerweise ein zeitdiskreter Strom von multidimensionalen Vektoren von Spektralwerten unterschiedlicher Signalobjektklassen und deren unterschiedlichen jeweiligen zeitlichen Spreizungen, wobei jedem dieser multidimensionalen Vektoren wieder ein Zeitstempel zugeordnet wird. Jeder dieser multidimensionalen Vektoren ist ein sogenannter Feature-Vektor. Es handelt sich somit um einen zeitdiskreten Strom von Feature-Vektoren. Jedem dieser Feature-Vektoren ist bevorzugt wieder ein Zeitstempel zugeordnet. (Schritt γb der Fig. 2).

Durch die fortlaufende zeitliche Verschiebung ergibt sich somit auch eine zeitliche Dimension. Hierdurch kann der Feature-Vektor der Spektralwerte auch um Werte der Vergangenheit oder Werte, die von diesen abhängen, beispielsweise zeitliche Integrale oder Ableitungen oder Filterwerte von einem odere mehreren dieser Werte etc. ergänzt werden. Dies kann die Dimensionalität dieser Feature-Vektoren innerhalb des Feature-Vektor-Datenstroms weiter erhöhen. Um den Aufwand im Folgenden klein zu halten, ist daher die Beschränkung auf wenige Signalobjektklassen während der Extraktion der Feature-Vektoren aus dem abgetasteten Empfangssignal des Ultraschallsensors sinnvoll. Somit können dann beispielsweise Optimalfilter (englisch matched filter) verwendet werden, um fortlaufend das Auftreten dieser Signalobjektklassen im Empfangssignal zu überwachen.

Als besonders einfache Signalobjektklassen können hier beispielsweise das gleichschenklige Dreieck und die Doppelspitze besonders benannt werden. Eine Signalobjektklasse besteht dabei in der Regel aus einem vorgegebenen Spektralkoeffizientenvektor, also einem vorgegebenen Feature-Vektor-Wert.

Für die Bestimmung der Relevanz der Spektralkoeffizienten eines Feature-Vektors eines Ultraschall-Echo-Signals erfolgt die Bestimmung des Betrags eines Abstands dieser Eigenschaften, der Elemente des Vektors der momentanen Spektralkoeffizienten (Feature-Vektor), zu zumindest einer Kombination dieser Eigenschaften (Prototyp) in Form einer Signalobjektklasse, die durch einen vorgegebenen Feature-Vektor (Prototyp oder Prototypenvektor) aus einer Bibliothek von vorgegebenen Signalobjektklassen-Vektoren symbolisiert wird (Schritt γd der Fig. 2). Bevorzugt werden die Spektralkoeffizienten des Feature-Vektors vor der Korrelation mit den Prototypen normiert (Schritt yc der Fig. 2). Der bei dieser Abstandsbestimmung ermittelte Abstand kann z.B. aus der Summe aller Differenzen zwischen jeweils einem Spektralkoeffizienten des vorgegebenen Feature-Vektors (Prototypen oder Prototypenvektors) des jeweiligen Prototypen und dem entsprechenden normierten Spektralkoeffizienten des aktuellen Feature-Vektors des Ultraschall-Echo-Signals bestehen. Ein euklidischer Abstand würde durch die Wurzel aus der Summe der Quadrate aller Differenzen zwischen jeweils einem Spektralkoeffizienten des vorgegebenen Feature-Vektors (Prototypen oder Prototypenvektors) des Prototypen und dem entsprechenden normierten Spektralkoeffizienten des aktuellen Feature-Vektors des Ultraschall-Echo-Signals gebildet werden. Diese Abstandsbildung ist aber in der Regel zu aufwändig. Andere Methoden der Abstandsbildung sind denkbar. Jedem vorgegebenen Feature-Vektor (Prototyp oder Prototypenvektor) kann dann ein Symbol und ggfs. auch ein Parameter, z.B. der Abstandswert und/oder die Amplitude vor der Normierung zugeordnet werden. Unterschreitet der so ermittelte Abstand einen ersten Schwellwert und ist es der kleinste Abstand des aktuellen Feature-Verktor-Werts zu einem der vorgegebenen Feature-Vektorwerte (Prototypen oder Werte der Prototypenvektoren), so wird dessen Symbol als erkannter Prototyp weiterverwendet. Es entsteht somit ein Paar aus erkanntem Prototypen und Zeitstempel des aktuellen Feature-Vektors. Es erfolgt dann bevorzugt die Übertragen der Daten (Schritt δ der Fig. 2), hier des ermittelten Symbols, das den erkannten Prototypen am besten symbolisiert, und beispielsweise des Abstands sowie der Zeitpunkt des Auftretens (Zeitstempels) an das Rechnersystem nur dann, wenn der Betrag dieses Abstands unter dem ersten Schwellwert liegt und der erkannte Prototyp ein zu übertragender Prototyp ist. Es kann nämlich sein, dass auch nicht zu erkennende Prototypen beispielsweise für Rauschen, also z.B. das nicht Vorhandensein von Reflexionen etc. hinterlegt werden. Diese Daten sind für die Hinderniserkennung irrelevant und sollen daher ggfs. auch nicht übertragen werden. Ein Prototyp wird also erkannt, wenn der Betrag des ermittelten Abstands zwischen aktuellem Feature-Vektor-Wert und vorgegebenen Feature-Vektor-Wert (Prototyp oder Wert des Prototypenvektors) unter diesem ersten Schwellwert liegt (Schritt γe der Fig. 2).

Bevorzugt wird also nicht mehr das Ultraschallechosignal selbst übertragen, sondern nur eine Folge von Symbolen für erkannte typische zeitliche Signalverläufe innerhalb des Echosignals und von diesen Signalverläufen zugehörigen Zeitstempeln in einem bestimmten Zeitabschnitt (Schritt δ der Fig. 2). Es wird dann bevorzugt jeweils je erkanntem Signalobjekt nur ein Symbol für den erkannten Signalformprototypen, dessen Parameter (z.B. Amplitude der Hüllkurve und/oder zeitliche Streckung) und ein zeitlicher Referenzpunkt des Auftretend dieses Signalformprototypen (der Zeitstempel) als erkanntes Signalobjekt übertragen. Die Übertragung der einzelnen Abtastwerte oder von Zeitpunkten, zu denen Schwellwerte durch die Hüllkurve des abgetasteten Empfangssignals überschritten werden etc. entfällt. Auf diese Weise führt diese Selektion der relevanten Prototypen zu einer massiven Datenkompression und zu einer Reduktion der benötigten Busbandbreite.

Es erfolgt also eine quantitative Erfassung des Vorliegens einer Kombination von Eigenschaften unter Bildung eines Schätzwertes - hier z.B. des inversen Abstands zwischen dem Repräsentanten der Signalobjektklasse in Form des vorgegebenen Feature-Vektors (Prototyp oder Prototypenvektor) - und das anschließende Übertragen der komprimierten Daten an das Rechnersystem, wenn der Betrag dieses Schätzwertes (z.B. inverser Abstand) oberhalb eines zweiten Schwellwerts bzw. der inverse Schätzwert unterhalb eines ersten Schwellwerts liegt. Die Signalverarbeitungseinheit des Ultraschallsensors führt somit eine Datenkompression des Empfangssignals zur Erzeugung komprimierter Daten aus. Der Ultraschallsensor überträgt dann die so komprimierten Daten, bevorzugt nur die Kodierungen (Symbole) der so erkannten Prototypen, deren Amplitude und/oder zeitliche Streckung und den Auftretenszeitpunkt (Zeitstempel) an das Rechnersystem. Hierdurch wird die EMV Belastung durch die Datenübertragung über den Datenbus zwischen Ultraschallsensor und Rechnersystem minimiert und in den zeitlichen Zwischenräumen können andere Daten wie z. B. Statusdaten des Ultraschallsensors zur Systemfehlererkennung an das Rechnersystem über den Datenbus zwischen Ultraschallsensor und Rechnersystem übertragen werden, was die Latenzzeit verbessert.

Im Rahmen der Erfindung hat sich gezeigt, dass Daten über den Datenbus priorisiert übertragen werden sollten. Meldungen sicherheitskritischer Fehler eines Sensors, also hier eines Ultraschallsensors, an das Rechnersystem haben dabei die höchste Priorität, da diese die Gültigkeit der Messdaten des Ultraschallsensors mit hoher Wahrscheinlichkeit beeinträchtigen. Diese Daten werden vom Sensor an das Rechnersystem gesendet. Die zweithöchste Priorität haben Anfragen des Rechnersystems zur Durchführung sicherheitsrelevanter Selbsttests. Solche Befehle werden vom Rechnersystem an den Sensor gesendet. Die dritthöchste Priorität haben die Daten des Ultraschallsensors selbst, da die Latenzzeit nicht erhöht werden darf. Alle anderen Daten haben hinsichtlich ihrer Übertragung über den Datenbus eine (noch) niedrigere Priorität.

Eine Variante des vorgeschlagenen Verfahrens sieht somit als ersten Schritt der Datenkompression das Bilden eines Feature-Vektor-Signals (Strom von Feature-Vektoren mit n Feature-Vektorwerten und n als Dimension des Feature-Vektors) aus dem Empfangssignal vor. Ein solches Feature-Vektor-Signal kann mehrere analoge und digitale Datensignale umfassen. Das Feature-Vektor-Signal stellt also eine zeitliche Folge von mehr oder weniger komplexen Daten/Signal-Strukturen dar. Im einfachsten Fall kann es als vektorielles Signal bestehend aus mehreren Teilsignalen aufgefasst werden.

Beispielsweise kann es sinnvoll sein, eine erste und/oder höhere zeitliche Ableitung des Empfangssignals oder das einfache oder mehrfache Integral des Empfangssignals zu bilden, was Teilsignale innerhalb des Feature-Vektor-Signals sind.

Es kann auch ein Hüllkurvensignal des Empfangssignals gebildet werden, das dann ein Teilsignal innerhalb des Feature-Vektor-Signals ist.

Des Weiteren kann es sinnvoll sein, das Empfangssignal mit dem ausgesendeten Ultraschallsignal zu falten und so ein Korrelationssignal zu bilden, das dann ein Teilsignal innerhalb des Feature-Vektor-Signals sein kann. Dabei kann zum einen das Signal als ausgesendetes Ultraschallsignal verwendet werden, das zur Ansteuerung des Treibers für den Sender verwendet wurde, oder zum anderen beispielsweise ein Signal verwendet werden, das am Sender gemessen wurde und so der tatsächlich abgestrahlten Schallwelle besser entspricht.

Schließlich kann es sinnvoll sein, durch Optimalfilter (englisch matched filter) das Auftreten vorbestimmter Signalobjekte zu detektieren und ein Optimalfiltersignal für das jeweilige Signalobjekt einiger der vorbestimmten Signalobjekte zu bilden. Unter Optimalfilter (engl. matched filter) versteht man hierbei ein Filter, welches das Signal-Rausch-Verhältnis (engl. signal to noise ratio, SNR) optimiert. In dem gestörten Ultraschallempfangssignal sollen die vordefinierten Signalobjekte erkannt werden. In der Literatur findet man auch häufig die Bezeichnungen Korrelationsfilter, Signal-angepasstes Filter (SAF) oder nur angepasstes Filter. Das Optimalfilter dient zur optimalen Bestimmung des Vorhandenseins (Detektion) einer bekannten Signalform, des vorbestimmten Signalobjekts, in Gegenwart von Störungen (Parameterschätzung). Diese Störungen können beispielsweise Signale anderer Ultraschallsender und/oder Bodenechos sein.

Die Optimalfilter-Ausgangssignale sind dann bevorzugt Teilsignale innerhalb des Feature-Vektor-Signals.

Bestimmte Ereignisse können in gesonderten Teilsignalen des Feature-Vektor-Signals signalisiert werden. Diese Ereignisse sind Signalgrundobjekte im Sinne dieser Erfindung. Signalgrundobjekte umfassen also nicht Signalformen, wie beispielsweise Rechteck-Pulse oder andere Formen von Wavelets oder Wellenzügen, sondern markante Punkte im Verlauf des Empfangssignals und/oder im Verlauf von daraus abgeleiteten Signalen, wie beispielsweise einem abgeleiteten Hüllkurvensignal, das beispielsweise durch Filterung aus dem Empfangssignal gewonnen werden kann.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben dritten Schwellwert kreuzt. Es handelt sich also um ein Signal, das das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben vierten Schwellwert, der mit dem dritten Schwellwert identisch sein kann aufsteigend kreuzt. Es handelt sich also um ein Signal, dass das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise detektieren, ob die Hüllkurve des Empfangssignals, das Hüllkurvensignal, einen vorgegeben fünften Schwellwert, der mit dem dritten oder vierten Schwellwert identisch sein kann, abfallend kreuzt. Es handelt sich also um ein Signal, dass das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise detektieren, ob die Hüllkurve des Empfangssignals, das Hüllkurvensignal, ein Maximum oberhalb eines sechsten Schwellwerts, der mit den vorgenannten dritten bis fünften Schwellwerten identisch sein kann, aufweist. Es handelt sich also um ein Signal, dass das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise detektieren, ob die Hüllkurve des Empfangssignals, das Hüllkurvensignal, ein Minimum oberhalb eines siebten Schwellwerts, der mit den vorgenannten dritten bis sechsten Schwellwerten identisch sein kann, aufweist. Es handelt sich also um ein Signal, dass das Vorliegen eines Signalgrundobjekts innerhalb des Empfangssignal und damit des Feature-Vektorsignals signalisiert.

Dabei wird bevorzugt ausgewertet, ob das zumindest eine vorausgehende Maximum der Hüllkurve einen Mindestabstand zu dem Minimum hat, um eine Detektion von Rauschen zu vermeiden. Andere diesbezügliche Filterungen sind denkbar. Auch kann geprüft werden, ob der zeitliche Abstand zwischen diesem Minimum und einem vorausgehenden Maximum größer ist, als ein erster zeitlicher Mindestabstand. Die Erfüllung dieser Bedingungen setzt jeweils ein Flag oder Signal, das selbst wieder bevorzugt ein Teilsignal des Feature-Vektor-Signals ist.

Ebenso sollte in entsprechender Weise überprüft werden, ob die zeitlichen und amplitudenmäßigen Abstände der anderen Signalobjekte gewissen Plausibilitätsanforderungen, wie die Einhaltung zeitlicher Mindestabstände und/oder von Mindestabständen in der Amplitude genügen. Auch aus diesen Prüfungen können sich weitere, auch analoge, binäre oder digitale Teilsignale abgeleitet werden, die somit das Feature-Vektor-Signal in seiner Dimensionalität weiter vergrößern.

Ggfs. kann in einer Signifikanzsteigerungsstufe das Feature-Vektor-Signal zu einem signifikanten Feature-Vektor-Signal z.B. durch eine lineare Abbildung oder durch ein Matrix-Polynom höherer Ordnung noch transformiert werden. In der Praxis hat sich aber gezeigt, dass dies zumindest für die heutigen Anforderungen noch nicht nötig ist.

Gemäß dem vorgeschlagenen Verfahren folgt das Erkennen und das Klassifizieren von Signalobjekten in erkannte Signalobjektklassen innerhalb des Empfangssignals auf Basis des Feature-Vektor-Signals oder des signifikanten Feature-Vektor-Signals.

Liegt beispielsweise die Amplitude des Ausgangssignals eines Optimalfilters und damit eines Teilsignals des Feature-Vektor-Signals oberhalb eines ggfs. optimalfilterspezifischen (z. B. achten) Schwellwerts, so kann das Signalobjekt, für dessen Detektion das Optimalfilter ausgelegt ist, als erkannt gelten. Dabei werden vorzugsweise auch andere Parameter berücksichtigt. Wurde beispielsweise ein Ultraschall-Burst mit ansteigender Frequenz während des Bursts gesendet (sogenanntes Chirp-Up), so wird auch ein Echo erwartet, dass diese Modulationseigenschaft aufweist. Stimmt die Signalform der Hüllkurve, beispielsweise eine dreieckige Signalform der Hüllkurve, zwar zeitlich lokal mit einer erwarteten Signalform überein, nicht aber mit der Modulationseigenschaft, so handelt es sich eben nicht um ein Echo des Senders, sondern um ein Störsignal, das z. B. von anderen Ultraschallsendern herrühren kann oder aus Überreichweiten. Insofern kann das System dann zwischen Eigenechos und Fremdechos unterscheiden, wodurch ein und dieselbe Signalform zwei unterschiedlichen Signalobjekten, nämlich Eigenechos und Fremdechos, zugeordnet wird. Die Übertragung der Eigenechos über den Datenbus vom Sensor zum Rechnersystem erfolgt dabei vorzugsweise priorisiert gegenüber der Übertragung der Fremdechos, da erstere in der Regel sicherheitsrelevant sind und die zweiten Echostypen in der Regel nicht sicherheitsrelevant sind.

Typischerweise wird bei der Erkennung jedem erkannten Signalobjekt zumindest ein Signalobjektparameter zugeordnet oder für dieses Signalobjekt bestimmt. Hierbei handelt es sich bevorzugt um einen Zeitstempel, der angibt, wann das Objekt empfangen wurde. Dabei kann der Zeitstempel sich beispielsweise auf den zeitlichen Beginn des Signalobjekts im Empfangssignal oder das zeitliche Ende oder die zeitliche Länge des Signalobjekts oder die zeitliche Lage des zeitlichen Schwerpunkts des Signalobjekts etc. beziehen. Auch sind andere Signalobjektparameter, wie Amplitude, Streckung etc. denkbar. In einer Variante des vorgeschlagenen Verfahrens wird somit zumindest einer der zugeordneten Signalobjektparameter mit einem Symbol für die mindestens eine Signalobjektklasse, zu der das mindestens eine erkannte Signalobjekt gehört, übertragen. Der Signalobjektparameter ist bevorzugt ein Zeitwert als Zeitstempel und gibt eine zeitliche Position an, die geeignet ist, daraus auf die Zeit seit Aussendung eines vorausgegangenen Ultraschall-Bursts schließen zu können. Vorzugsweise erfolgt daraus später die Ermittlung eines Abstands eines Objekts in Abhängigkeit von einem dermaßen ermittelten und übertragenen Zeitwert.

Es folgt schließlich das priorisierte Übertragen der erkannten Signalobjektklassen in Form zugeordneter Symbole mit Zeitstempeln vorzugsweise jeweils zusammen mit den zugeordneten Signalobjektparametern. Die Übertragung kann auch in komplexeren Datenstrukturen (englisch: Records) erfolgen. Beispielsweise ist es denkbar, zuerst die Zeitpunkte der erkannten sicherheitsrelevanten Signalobjekte (für z.B. identifizierte Hindernisse) zu übertragen und dann die erkannten Signalobjektklassen der sicherheitsrelevanten Signalobjekte. Hierdurch wird die Latenzzeit weiter verringert.

Das vorgeschlagene Verfahren umfasst zumindest in einer Variante das Ermitteln eines Chirp-Werts als zugeordneter Signalobjektparameter, der angibt, ob es sich bei dem erkannten Signalobjekt um ein Echo eines Ultraschall-Sende-Bursts mit Chirp-Up oder mit Chirp-Down oder mit No-Chirp-Eigenschaften handelt. Chirp-Up bedeutet, dass die Frequenz innerhalb des empfangenen Signalobjekts im Empfangssignal ansteigt. Chirp-Down bedeutet, dass die Frequenz innerhalb des empfangenen Signalobjekts im Empfangssignal abfällt. No-Chirp bedeutet, dass die Frequenz innerhalb des empfangenen Signalobjekts im Empfangssignal im Wesentlichen gleichbleibt.

In einer Variante des Verfahrens wird somit auch ein Confidence-Signal durch Bildung der Korrelation, z.B. durch Bildung eines zeitkontinuierlichen oder zeitdiskreten Korrelationsintegrals zwischen dem Empfangssignal oder statt des Empfangssignals mit einem aus dem Empfangssignal abgeleiteten Signal einerseits und einem Referenzsignal, beispielsweise dem Ultraschallsendesignal oder einem anderen erwarteten Wavelet, andererseits gebildet. Das Confidence-Signal ist dann typischerweise ein Teilsignal des Feature-Vektor-Signals, also eine Komponente des Feature-Vektors, der aus einer Folge vektorieller Abtastwerte (Feature-Vektor-Werte) besteht.

In einer Variante des Verfahrens wird auf dieser Basis auch ein Phasen-Signal gebildet, das die Phasenverschiebung beispielsweise des Empfangssignals oder eines daraus gebildeten Signals (z.B. des Confidence-Signals) gegenüber einem Referenzsignal, beispielsweise dem Ultraschallsendesignal und/oder einem anderen Typ von Referenzsignal angibt. Das Phasen-Signal ist dann typischerweise ebenfalls ein Teilsignal des Feature-Vektor-Signals, also eine Komponente des Feature-Vektors, der aus einer Folge vektorieller Abtastwerte besteht.

In ähnlicher Weise kann in einer weiteren Variante des vorgeschlagenen Verfahrens ein Phasen-Confidence-Signal durch Bildung der Korrelation zwischen dem Phasen-Signal oder einem daraus abgeleiteten Signal einerseits und einem Referenzsignal gebildet und als Teilsignal des Feature-Vektor-Signals verwendet werden. Das Phasen-Confidence-Signal ist dann typischerweise ebenfalls ein Teilsignal des Feature-Vektor-Signals, also eine Komponente des Feature-Vektors, der aus einer Folge vektorieller Abtastwerte besteht.

Bei der Auswertung des Feature-Vektor-Signals kann es nun sinnvoll sein, einen Vergleich des Phasen-Confidence-Signals mit einem oder mehreren Schwellwerten zur Erzeugung eines diskretisierten Phasen-Confidence-Signals durchzuführen, das selbst wieder ein Teilsignal des Feature-Vektor-Signals werden kann.

Die Auswertung des Feature-Vektor-Signals und/oder des signifikanten Feature-Vektor-Signals kann in einer Variante des vorgeschlagenen Verfahrens so erfolgen, dass ein oder mehrere Abstandswerte zwischen dem Feature-Vektor-Signal und einem oder mehreren Signalobjektprototypenwerten für erkennbare Signalobjektklassen gebildet werden. Ein solcher Abstandswert kann boolesch, binär, diskret, digital oder analog sein. Vorzugsweise werden alle Abstandswerte in einer nichtlinearen Funktion miteinander verknüpft. So kann bei einem erwarteten Chirp-Up-Echo in Dreiecksform ein empfangenes Chirp-Down-Echo in Dreiecksform verworfen werden. Dieses Verwerfen ist im Sinne der Erfindung ein "nichtlinearer" Vorgang.

Umgekehrt kann das Dreieck im Empfangssignal unterschiedlich ausgeprägt sein. Dies betrifft in erster Linie die Amplitude des Dreiecks im Empfangssignal. Ist die Amplitude im Empfangssignal hinreichend, so liefert beispielsweise das diesem Dreiecksignal zugeordnete Optimalfilter ein Signal oberhalb eines vorgegebenen neunten Schwellwerts. In dem Fall kann dann beispielsweise dieser Signalobjektklasse (für Dreiecksignale) ein erkanntes Signalobjekt zum Zeitpunkt des Überschreitens zugeordnet werden. In dem Fall unterschreitet der Abstandswert zwischen dem Feature-Vektor-Signal und dem Prototypen (hier der neunte Schwellwert) einen oder mehrere vorbestimmte, binäre, digitale oder analoge Abstandswerte (hier 0= Kreuzung).

Es wurde im Rahmen der Erfindung erkannt, dass es vorteilhaft ist, die Daten der erkannten Signalobjekte der sehr schnell eintreffenden Echos zuerst vom Sensor zum Rechnersystem zu übertragen und dann erst die nachfolgenden Daten der später erkannten Signalobjekte. Vorzugsweise wird dabei immer zumindest die erkannte Signalobjektklasse und ein Zeitstempel übertragen, der vorzugsweise angeben sollte, wann das Signalobjekt beim Sensor wieder eingetroffen ist. Im Rahmen des Erkennungsprozesses können den verschiedenen Signalobjekten, die für einen Abschnitt des Empfangssignals in Frage kommen, Scores zugeordnet werden, die angeben, welche Wahrscheinlichkeit entsprechend dem verwendeten Schätzalgorithmus dem Vorliegen dieses Signalobjekts zugeordnet wird. Ein solcher Score ist im einfachsten Fall binär. Vorzugsweise handelt es sich jedoch um eine komplexe, reelle oder Integer-Zahl. Es kann sich beispielsweise um den ermittelten Abstand handeln. Sofern mehrere Signalobjekte einen hohen Score-Wert haben, ist es sinnvoll, in manchen Fällen auch die Daten erkannter Signalobjekte mit niedrigeren Score-Werten zu übertragen. Um dem Rechnersystem die richtige Handhabung zu ermöglichen, sollten für diesen Fall nicht nur das Datum (Symbol) des erkannten Signalobjekts und der Zeitstempel für das jeweilige Signalobjekt übertragen werden, sondern auch der ermittelte Score-Wert. Statt nur Datum (Symbol) des erkannten Signalobjekts und den Zeitstempel für das diesem Symbol entsprechende Signalobjekt zu übertragen, kann zusätzlich auch das Datum (Symbol) des Signalobjekts mit dem zweit kleinsten Abstand und dessen Zeitstempel für das diesem zweitwahrscheinlichsten Symbol entsprechende Signalobjekt mitübertragen werden. Somit wird in diesem Fall eine Hypothensenliste aus zwei erkannten Signalobjekten und deren zeitlichen Positionen sowie zusätzlich zugeordneten Score-Werten an das Rechnersystem übertragen. Ebenso kann auch die Übertragung einer Hypothensenliste bestehend aus mehr als zwei Symbolen für mehr als zwei erkannte Signalobjekte und deren zeitliche Positionen sowie zusätzlich zugeordnete Score-Werte an das Rechnersystem erfolgen.

Vorzugsweise erfolgt die Übertragung der Daten der erkannten Signalobjektklasse und der zugeordneten Daten wie beispielsweise Zeitstempel und Score-Werte der jeweiligen erkannten Signalobjektklassen, also der zugeordneten Signalobjektparameter, nach dem FIFO-Prinzip. Dies stellt sicher, dass stets die Daten der Reflektionen der am nächsten liegenden Objekte zuerst übertragen werden und so der sicherheitskritische Fall des Zusammenstoßes des Fahrzeugs mit einem Hindernis priorisiert nach Wahrscheinlichkeit bearbeitet wird.

Neben der Übertragung von Messdaten kann auch die Übertragung von Fehlerzuständen des Sensors erfolgen. Dies kann auch während einer Empfangszeit (T_{E}) geschehen, wenn der Sensor durch Selbsttestvorrichtungen feststellt, dass ein Defekt vorliegt und die zuvor übertragenen Daten fehlerhaft sein könnten. Somit wird sichergestellt, dass das Rechnersystem zum frühestmöglichen Zeitpunkt über eine Änderung der Bewertung der Messdaten Kenntnis erlangen kann und diese verwerfen oder anders behandeln kann. Dies ist von besonderer Bedeutung für Notbremssysteme, da eine Notbremsung ein sicherheitskritischer Eingriff ist, der nur dann eingeleitet werden darf, wenn die zugrundeliegenden Daten einen entsprechenden Vertrauenswert besitzen, und für andere Fahrerassistenzsysteme. Demgegenüber wird daher die Übertragung der Messdaten, also beispielsweise des Datums der erkannten Signalobjektklasse und/oder die Übertragung des einen zugeordneten Signalobjektparameters zurückgestellt und damit niedriger priorisiert. Auch ist ein Abbruch der Übertragung bei Auftreten eines Fehlers im Sensor denkbar. Es kann aber auch ein Fehler möglich erscheinen, aber nicht sicher vorliegen. Insofern ist in solchen Fällen unter Umständen die Fortsetzung einer Übertragung angezeigt. Die Übertragung sicherheitskritischer Fehler des Sensors erfolgt somit vorzugsweise höher priorisiert.

Neben den bereits beschriebenen Wavelets mit einem Integralwert von 0 und den zusätzlich hier als Wavelet bezeichneten Signalabschnitten mit einem Integralwert verschieden von 0 können auch bestimmte Stellen/Phasen im Verlauf des Empfangssignals als Signalgrundobjekt im Sinne dieser Erfindung aufgefasst werden, die zu einer Datenkompression verwendet werden können und anstelle von Abtastwerten des Empfangssignals übertragen werden können.

Diese Untermenge in der Menge möglicher Signalgrundobjekte wird im Folgenden als Signalzeitpunkte bezeichnet. Die Signalverlaufspunkte sind also im Sinne dieser Erfindung eine spezielle Form der Signalgrundobjekte.

Ein erster möglicher Signalverlaufspunkt und damit ein Signalgrundobjekt ist ein Kreuzen des Verlaufs des Hüllkurvensignals (1) mit einem Schwellwertsignal (SW) in aufsteigender Richtung.

Ein zweiter möglicher Signalverlaufspunkt und damit ein Signalgrundobjekt ist ein Kreuzen des Verlaufs des Hüllkurvensignals (1) mit einem Schwellwertsignal (SW) in absteigender Richtung.

Ein dritter möglicher Signalverlaufspunkt und damit ein Signalgrundobjekt ist ein örtliches oder absolutes Maximum im Verlauf des Hüllkurvensignals (1) oberhalb der Amplitude eines dreizehnten Schwellwertsignals (SW).

Ein vierter möglicher Signalverlaufspunkt und damit ein Signalgrundobjekt ist ein örtliches oder absolutes Minimum im Verlauf des Hüllkurvensignals (1) oberhalb eines Schwellwertsignals (SW).

Ggfs. kann es sinnvoll sein, für diese vier beispielhaften Typen von Signalverlaufspunkten und weitere Typen von Signalverlaufspunkten signalgrundobjekttypische Schwellwertsignale (SW) zu verwenden.

Die zeitliche Abfolge von Signalgrundobjekten ist typischerweise nicht beliebig. Dies wird erfindungsgemäß ausgenutzt, da bevorzugt nicht die Signalgrundobjekte, die einfacherer Natur sind, übertragen werden sollen, sondern erkannte Muster von zeitlichen Abfolgen dieser Signalgrundobjekten, die dann die eigentlichen Signalobjekte darstellen. Wird beispielsweise ein Dreiecks-Wavelet im Hüllkurvensignal (1) ausreichender Höhe erwartet, so kann zusätzlich zu einem entsprechenden Mindestpegel am Ausgang eines für die Detektion eines solchen Dreiecks-Wavelets geeigneten Optimal-Filters
1. das Auftreten eines ersten möglichen Signalverlaufspunkts beim Kreuzen der Amplitude des Hüllkurvensignals (1) mit einem Schwellwertsignal (SW) in aufsteigender Richtung und daran zeitlich anschließend
2. das Auftreten eines zweiten möglichen Signalverlaufspunkts bei einem Maximum des Hüllkurvensignals (1) oberhalb eines oder des Schwellwertsignals (SW) und daran zeitlich anschließend
3. das Auftreten eines dritten möglichen Signalverlaufspunkts beim Kreuzen des Hüllkurvensignals (1) mit einem oder dem Schwellwertsignal (SW) in absteigender Richtung

in zeitlicher Korrelation zum Überschreiten des besagten Mindestpegels am Ausgang des besagten Optimal-Filters erwartet werden. Das beispielhafte Signalobjekt eines Dreiecks-Wavelets besteht in diesem Beispiel also in der vordefinierten Abfolge von drei Signalgrundobjekten, mittels derer ein Signalobjekt erkannt und einer Signalobjektklasse zugeordnet wird, wobei dies Information als Symbol der Signalobjektklasse und durch das erkannte Signalobjekt beschreibenden Parameter wie z. B. insbesondere dem Auftretenszeitpunkt, d. h. den Zeitstempel, übertragen wird. Dieses Überschreiten des besagten Mindestpegels am Ausgang des besagten Optimal-Filters ist übrigens ein weiteres Beispiel für einen fünften möglichen Signalzeitpunkt und damit ein weiteres mögliches Signalgrundobjekt.

Die sich somit ergebende Gruppierung und zeitliche Abfolge von erkannten Signalgrundobjekten kann selbst, beispielsweise durch einen Viterbi-Decoder, als eine vordefinierte, erwartete Gruppierung oder zeitliche Abfolge von Signalgrundobjekten erkannt werden und kann somit selbst wieder ein Signalgrundobjekt darstellen. Somit ist ein sechster möglicher Signalverlaufspunkt und damit ein Signalgrundobjekt das Auftreten einer solchen vordefinierten Gruppierung und/oder zeitliche Abfolge von anderen Signalgrundobjekten.

Wird eine solche Gruppierung von Signalgrundobjekten oder zeitliche Abfolge solcher Signalobjektklassen in Form eines Signalobjekts erkannt, so folgt das Übertragen des Symbols dieser erkannten zusammenfassenden Signalobjektklasse und zumindest des einen zugeordneten Signalobjektparameters vorzugsweise an Stelle der Übertragung der einzelnen Signalgrundobjekte, da hierdurch erhebliche Datenbuskapazität gespart wird. Es mag jedoch auch Fälle geben, in denen beides übertragen wird. Hierbei wird das Datum (Symbol) der Signalobjektklasse eines Signalobjekts übertragen, das eine vordefinierte zeitliche Abfolge und/oder Gruppierung von anderen Signalgrundobjekten ist. Um eine Kompression zu erreichen, ist es vorteilhaft, wenn zumindest eine Signalobjektklasse (Symbol) zumindest eines dieser anderen Signalgrundobjekte nicht übertragen wird.

Eine zeitliche Gruppierung von Signalgrundobjekten liegt insbesondere dann vor, wenn der zeitliche Abstand dieser Signalgrundobjekte einen vordefinierten Abstand nicht überschreitet. Im zuvor erwähnten Beispiel sollte die Laufzeit des Signals im Optimalfilter bedacht werden. Typischerweise dürfte das Optimalfilter langsamer als die Komparatoren sein. Daher sollte der Wechsel im Ausgangssignal des Optimalfilters in einem festen zeitlichen Zusammenhang zu dem zeitlichen Auftreten der relevanten Signalzeitpunkte stehen.

Gemäß einer Variante der Erfindung wird also ein Verfahren zur Übertragung von Sensordaten, erfindungsgemäß mindestens zweier Ultraschallsensoren, von einem Sensor zu einem Rechnersystem, erfindungsgemäß in einem Fahrzeug, vorgeschlagen, das nach dem Aussenden eines Ultraschall-Bursts sowie dem Empfangen eines Ultraschallsignals und dem Bilden eines zeitdiskreten Empfangssignals bestehend aus einer Folge von Abtastwerten beginnt. Jedem Abtastwert ist dabei ein zeitliches Datum (Zeitstempel) zugeordnet. Das Verfahren beginnt mit der Bestimmung von mindestens zwei Parametersignalen jeweils betreffend das Vorliegen jeweils eines dem jeweiligen Parametersignal zugeordneten Signalgrundobjekts mit Hilfe mindestens eines geeigneten Filters (z.B. eines Optimalfilters) aus der Folge von Abtastwerten des Empfangssignals. Die sich ergebenden Parametersignale (Feature-Vektor-Signale) sind ebenfalls als zeitdiskrete Folge von jeweiligen Parametersignalwerten (Feature-Vektor-Werte) ausgebildet, die jeweils mit einem Datum (Zeitstempel) korreliert sind. Somit ist bevorzugt jedem Parametersignalwert (Feature-Vektor-Wert) genau ein zeitliches Datum (Zeitstempel) zugeordnet. Diese Parametersignale zusammen werden im Folgenden als Feature-Vektor-Signal bezeichnet. Das Feature-Vektor-Signal ist somit als zeitdiskrete Folge von Feature-Vektor-Signalwerten mit jeweils n Parametersignalwerten ausgebildet ist, die aus den Parametersignalwerten und weiteren Parametersignalwerten mit jeweils gleichem zeitlichen Datum (Zeitstempel) bestehen. Hierbei ist n die Dimensionalität der einzelnen Feature-Vektor-Signalwerte, die bevorzugt von einem Feature-Vektorwert zum nächsten Feature-Vektorwert gleich sind. Jedem so gebildeten Feature-Vektor-Signalwert wird dieses jeweilige zeitliche Datum (Zeitstempel) zugeordnet. Es folgt die Auswertung des zeitlichen Verlaufs des Feature-Vektor-Signals in dem sich ergebenden n-dimensionalen Phasenraum sowie das Schließen auf ein erkanntes Signalobjekt unter Ermittlung eines Bewertungswerts (z.B. des Abstands). Wie zuvor erläutert, besteht dabei ein Signalobjekt aus einer zeitlichen Abfolge von Signalgrundobjekten. Dem Signalobjekt ist dabei typischerweise vordefiniert ein Symbol zugeordnet. Bildlich gesprochen wird hier geprüft, ob der Punkt, auf den das n-dimensionale Feature-Vektor-Signal im n-dimensionalen Phasenraum zeigt, bei seinem Wege durch den n-dimensionalen Phasenraum in vorbestimmter zeitlicher Abfolge sich vorbestimmten Punkten in diesem n-dimensionalen Phasenraum in geringerem Abstand als ein vorgegebener Maximalabstand nähert. Das Feature-Vektor-Signal hat also einen zeitlichen Verlauf. Es wird dann ein Bewertungswert (z.B. ein Abstand) berechnet, der beispielsweise der Wahrscheinlichkeit für das Vorliegen einer bestimmten Abfolge wiedergeben kann. Es erfolgt dann der Vergleich dieses Bewertungswerts, dem wieder ein zeitliches Datum (Zeitstempel) zugeordnet ist, mit einem Schwellwertvektor unter Bildung eines booleschen Resultats, dass einen ersten und einen zweiten Wert haben kann. Wenn dieses boolesche Resultat für dieses zeitliche Datum (Zeitstemple) den ersten Wert hat, erfolgt ein Übertragen des Symbols des Signalobjekts und des diesem Symbol zugeordneten zeitlichen Datums (Zeitstempel) von dem Sensor zu dem Rechnersystem. Ggfs. können je nach erkanntem Signalobjekt weitere Parameter übertragen werden.

Für die vorstehenden Ausführungen sowie für die nachfolgenden Erläuterungen gilt gleichermaßen, dass die komprimierten Echosignalabschnittsdaten in dem Rechnersystem verarbeitet werden, indem die die Echosignalabschnitte der Signalverlaufsobjekte repräsentierenden, komprimierten Echosignalabschnittsdaten durch Dekompression zu rekonstruierten Ultraschallempfangssignalen rekonstruiert werden, wobei mit Hilfe der rekonstruierten Ultraschallempfangssignale eine Erkennung von Hindernissen im Umfeld der Sensoren durchgeführt wird.

Besonders bevorzugt erfolgt die Datenübertragung im Fahrzeug an das Rechnersystem über einen seriellen bidirektionalen Eindraht-Datenbus. Die elektrische Rückleitung wird hierbei bevorzugt durch die Karosserie des Fahrzeugs sichergestellt. Vorzugsweise werden die Sensordaten strommoduliert an das Rechnersystem gesendet. Die Daten zur Steuerung eines

Sensors werden durch das Rechnersystem vorzugsweise spannungsmoduliert an den Sensor gesendet. Es wurde erkannt, dass die Verwendung eines PSI5-Datenbusses und/oder eines DSI3-Datenbusses für die Datenübertragung besonders geeignet ist. Des Weiteren wurde erkannt, dass es besonders vorteilhaft ist, die Übertragung der Daten an das Rechnersystem mit einer Übertragungsrate von > 200 kBit/s und vom Rechnersystem zu dem mindestens einen Sensor mit einer Übertragungsrate > 10 kBit/s, vorzugsweise 20 kBit/s vorzunehmen. Des Weiteren wurde erkannt, dass die Übertragung von Daten von dem Sensor an das Rechnersystem mit einem Sendestrom auf den Datenbus moduliert werden sollte, dessen Stromstärke weniger als 50 mA, bevorzugt weniger als 5 mA, bevorzugt weniger als 2,5mA betragen sollte. Für diese Betriebswerte müssen diese Busse entsprechend angepasst werden. Das Grundprinzip bleibt aber bestehen.

Für die Durchführung der zuvor beschriebenen Verfahren wird ein Rechnersystem mit einer Datenschnittstelle zu dem besagten Datenbus, vorzugsweise dem besagten Eindrahtdatenbus, benötigt, wobei das Rechnersystem die Dekompression der dermaßen komprimierten Daten unterstützt. In der Regel wird das Rechnersystem jedoch keine vollständige Dekompression vornehmen, sondern beispielsweise lediglich den Zeitstempel und den erkannten Signalobjekttyp auswerten. Ein

Sensor, der zur Durchführung eines der zuvor beschrieben Verfahren benötigt wird, weist mindestens einen Sender und mindestens einen Empfänger zur Erzeugung eines Empfangssignals auf, die auch als ein gemeinsamer oder als mehrere Transducer kombiniert vorliegen können. Des Weiteren weist der Sensor zumindest Vorrichtungen zur Verarbeitung und Kompression des Empfangssignals auf sowie eine Datenschnittstelle zur Übertragung der Daten über den Datenbus, vorzugsweise den besagten Eindrahtdatenbus, an das Rechnersystem auf. Für die Datenkompression weist die Vorrichtung vorzugsweise zumindest eine der folgenden Einheiten auf:
- Optimalfilter,
- Komparatoren,
- Schwellwertsignalerzeugungsvorrichtungen zur Erzeugung eines oder mehrerer Schwellwertsignale (SW),
- Differenzierer zur Bildung von Ableitungen,
- Integrierer zur Bildung integrierter Signale,
- sonstige Filter,
- Hüllkurvenformer zur Erzeugung eines Hüllkurvensignals aus dem Empfangssignal,
- Korrelationsfilter zum Vergleich des Empfangssignals oder von daraus abgeleiteten Signalen mit Referenzsignalen.

In einer besonders einfachen Form wird das vorgeschlagene Verfahren folgt ausgeführt: Vorgeschaltet ist z. B. das Aussenden eines Ultraschall-Bursts und das Empfangen eines Ultraschallsignals, also typischerweise einer Reflektion sowie das Bilden eines zeitdiskreten Empfangssignals bestehend aus einer zeitlichen Folge von Abtastwerten. Dabei ist jedem Abtastwert ein zeitliches Datum (Zeitstemple) zugeordnet. Dieses gibt den Zeitpunkt der Abtastung typischerweise wieder. Auf Basis dieses Datenstroms erfolgt erfindungsgemäß die Bestimmung eines ersten Parametersignals einer ersten Eigenschaft mit Hilfe eines ersten Filters aus der Folge von Abtastwerten des Empfangssignals. Bevorzugt wird dabei das Parametersignal wieder als zeitdiskrete Folge von Parametersignalwerten ausgebildet. Jedem Parametersignalwert wird wieder genau ein zeitliches Datum (Zeitstempel) zugeordnet. Bevorzugt entspricht dieses Datum dem jüngsten zeitlichen Datum eines Abtastwertes, der zur Bildung dieses jeweiligen Parametersignalwertes benutzt wurde. Zeitlich parallel dazu erfolgt bevorzugt die Bestimmung mindestens eines weiteren Parametersignals und/oder einer diesem weiteren Parametersignal zugeordneten Eigenschaft mit Hilfe eines diesem weiteren Parametersignal zugeordneten weiteren Filters aus der Folge von Abtastwerten des Empfangssignals, wobei die weiteren Parametersignale jeweils wieder als zeitdiskrete Folgen von weiteren Parametersignalwerten ausgebildet sind. Auch hier wird jedem weiteren Parametersignalwert jeweils das gleiche zeitliche Datum (Zeitstempel) wie dem entsprechenden Parametersignalwert zugeordnet.

Das erste Parametersignal und die weiteren Parametersignale werden zusammen im Folgenden als Parametervektorsignal oder auch als Feature-Vektor-Signal bezeichnet. Dieses Feature-Vektor-Signal stellt somit eine zeitdiskrete Folge von Feature-Vektor-Signalwerten dar, die aus den Parametersignalwerten und weiteren Parametersignalwerten mit jeweils gleichem zeitlichen Datum (Zeitstempel) bestehen. Somit kann jedem so gebildeten Feature-Vektor-Signalwert, d. h. jedem Parametersignalwert dieses jeweilige zeitliche Datum (Zeitstempel) zugeordnet werden.

Es erfolgt bevorzugt dann quasikontinuierlich der Vergleich der Feature-Vektor-Signalwerte eines zeitlichen Datums (Zeitstempels) mit einem Schwellwertvektor, der bevorzugt ein Prototypenvektor ist, unter Bildung eines booleschen Resultats, dass einen ersten und einen zweiten Wert haben kann, Beispielsweise ist es denkbar, den Betrag des aktuellen Feature-Vektor-Signalwerts, der beispielsweise eine erste Komponente eines Feature-Vektor-Signalwerts darstellt, mit einem Schwellwert, der eine erste Komponente des Schwellwertvektors darstellt, zu vergleichen und das boolesche Resultat auf einen ersten Wert zu setzen, wenn der Betrag des Feature-Vektor-Signalwerts kleiner ist als dieser Schwellwert, und auf einen zweiten Wert, wenn das nicht der Fall ist. Hat das boolesche Resultat einen ersten Wert, so ist es dann weiter denkbar, den Betrag des weiteren Feature-Vektor-Signalwerts, der beispielsweise eine weitere Komponente dieses Feature-Vektor-Signals darstellt, mit einem weiteren Schwellwert, der eine weitere Komponente des Schwellwertvektors darstellt, zu vergleichen und entweder das boolesche Resultat auf dem ersten Wert zu belassen, wenn der Betrag des weiteren Feature-Vektor-Signalwerts kleiner ist als dieser weitere Schwellwert, oder das boolesche Resultat auf den zweiten Wert zu setzen, wenn dies nicht der Fall ist. Auf diese Weise können alle weiteren Feature-Vektor-Signalwerte überprüft werden. Natürlich sind auch andere Klassifikatoren denkbar. Auch ist der Vergleich mit mehreren verschiedenen Schwellwertvektoren möglich. Diese Schwellwertvektoren stellen also die Prototypen vorgegebener Signalformen dar. Sie entstammen der besagten Bibliothek. Jedem Schwellwertvektor ist wieder bevorzugt ein Symbol zugeordnet.

Als letzter Schritt folgt dann in diesem Fall das Übertragen des Symbols und ggfs. auch der Feature-Vektor-Signalwerte und des diesem Symbol bzw. Feature-Vektor-Signalwert zugeordneten zeitlichen Datums (Zeitstempels) von dem Sensor zu dem Rechnersystem, wenn das boolesche Resultat für dieses zeitliche Datum (Zeitstempel) den ersten Wert hat.

Somit werden alle anderen Daten nicht (mehr) übertragen. Des Weiteren werden durch die mehrdimensionale Auswertung Störungen vermieden.

Auf dieser Basis wird somit ein Sensorsystem vorgeschlagen mit mindestens einem Rechnersystem, das zur Durchführung eines der zuvor vorgestellten Verfahren in der Lage ist, und mit mindestens zwei Sensoren, die ebenfalls zur Durchführung eines der zuvor vorgestellten Verfahren in der Lage sind, so dass diese mindestens zwei Sensoren mit dem Rechnersystem durch Signalobjekterkennung kommunizieren können und auch in die Lage versetzt sind, Fremdechos kompaktiert zu übertragen und diese Informationen zusätzliche dem Rechnersystem zur Verfügung zu stellen. Das Sensorsystem ist dementsprechend dazu typischerweise vorgesehen, dass die Datenübertragung zwischen den mindestens zwei Sensoren und dem Rechnersystem entsprechend den zuvor beschriebenen Verfahren abläuft oder ablaufen kann. Innerhalb der mindestens zwei Sensoren des Sensorsystems wird also typischerweise jeweils ein Ultraschallempfangssignal, also mindestens zwei Ultraschallempfangssignale, mittels eines der zuvor vorgeschlagenen Verfahren komprimiert und an das Rechnersystem übertragen. Dabei werden innerhalb des Rechnersystems die mindestens zwei Ultraschallempfangssignale zu rekonstruierten Ultraschallempfangssignalen rekonstruiert. Das Rechnersystem führt dann mit Hilfe von rekonstruierten Ultraschallempfangssignalen eine Objekterkennung von Objekten im Umfeld der Sensoren durch. Die Sensoren führen diese Objekterkennung im Gegensatz zum Stand der Technik also nicht durch. Sie liefern lediglich die Daten betreffend die Kodierung von erkannten Signalobjekten und deren Parameter und übertragen damit den Empfangssignalverlauf komprimiert.

Das Rechnersystem führt mit Hilfe der durch Dekompression der komprimierten Echosignalabschnittsdaten erzeugten rekonstruierten Ultraschallempfangssignale und ggfs. zusätzlicher Signale von weiteren Sensoren, insbesondere der Signale von Radar-Sensoren, eine Erkennung von Objekten, d.h. Hindernissen im Umfeld der Sensoren durch.

Als letzten Schritt erstellt bevorzugt das Rechnersystem aus Basis der erkannten Objekte eine Umfeldkarte für die Sensoren oder eine Vorrichtung, zu der die Sensoren gehören bzw. die als einen Bestandteil die Sensoren aufweist.

Die erfindungsgemäß vorgeschlagene komprimierte Übertragung von Signalverlaufsdaten zwischen Sensor und Rechnersystem über den Datenbus senkt zum einen die Datenbuslast und damit die Kritizität gegenüber EMV-Anforderungen und schafft zum anderen freie Datenbuskapazitäten für die Übertragung von Steuerbefehlen vom Rechnersystem zum Sensor und zur Übertragung von Statusinformationen und sonstigen Daten vom Sensor zum Rechnersystem. Die vorgeschlagene Priorisierung mit der die komprimierten Daten des Empfangssignalverlaufs und anderen Daten wie Statusinformationen oder Fehlermeldungen übertragen werden, stellt dabei sicher, dass sicherheitsrelevante Daten zuerst übertragen werden und so keine unnötigen Totzeiten des Sensors entstehen.

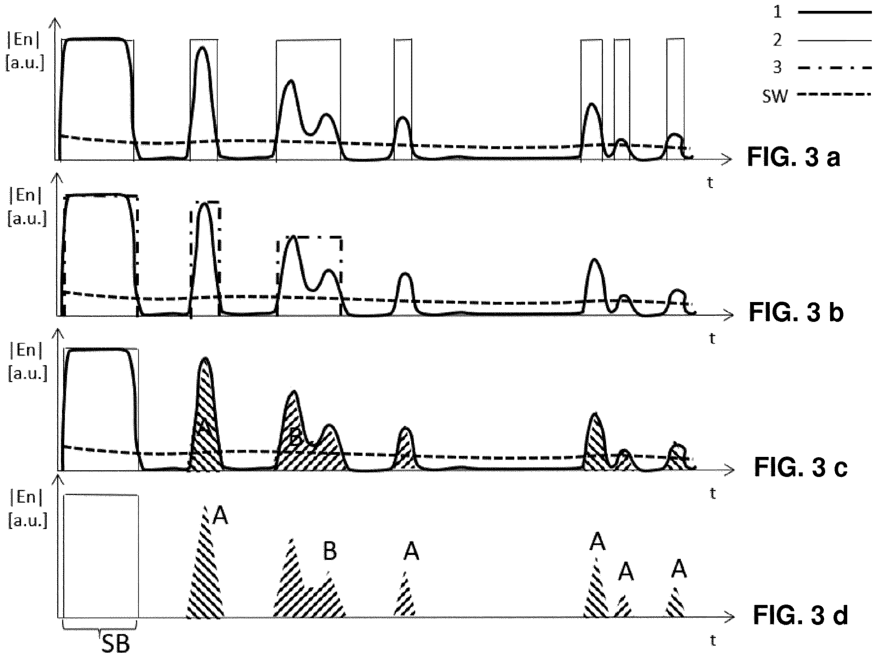

Fig. 3a zeigt den zeitlichen Verlauf eines herkömmliches Ultraschall-Echo-Signals (1) (siehe die breitere durchgezogene Linie) und dessen konventionelle Auswertung in frei gewählten Einheiten. Beginnend mit dem Aussenden des Sende-Bursts (SB) (siehe den äußerst links gezeigten Signalverlaufsabschnitt und die Bezeichnung mit SB in Fig. 3d) wird ein Schwellwertsignal (SW) (siehe die gestrichelte Linie) mitgeführt. Immer dann, wenn das Hüllkurvensignal des Ultraschall-Echo-Signals (1) das Schwellwertsignal (SW) übersteigt, wird der Ausgang (2) (siehe die dünnere durchgezogene Linie) auf logisch 1 gesetzt. Es handelt sich um eine zeitlich analoge Schnittstelle mit einem digitalen Ausgangspegel. Die weitere Auswertung wird dann im Steuergerät des Sensors übernommen. Eine Signalisierung von Fehlern oder eine Steuerung des Sensors ist über diese dem Stand der Technik entsprechende analoge Schnittstelle nicht möglich.

Fig. 3b zeigt den zeitlichen Verlauf eines herkömmliches Ultraschall-Echo-Signal (1) und dessen konventionelle Auswertung in frei gewählten Einheiten. Beginnend mit dem Aussenden des Sende-Bursts (SB) wird ein Schwellwertsignal (SW) mitgeführt. Immer dann, wenn das Hüllkurvensignal des Ultraschall-Echo-Signals (1) das Schwellwertsignal (SW) übersteigt, wird der Ausgang (2) nun jedoch auf einen Pegel entsprechend der Größe der erfassten Reflektion gesetzt (siehe die breitere strichpunktierte Linie). Es handelt sich um eine zeitlich analoge Schnittstelle mit einem analogen Ausgangspegel. Die weitere Auswertung wird dann im Sensor vorgenommen. Eine Signalisierung von Fehlern oder eine Steuerung des Sensors ist über diese dem Stand der Technik entsprechende analoge Schnittstelle nicht möglich.

Fig. 3c zeigt zur Erläuterung das Ultraschall-Echo-Signal, wobei die Chirp-Richtung (z.B. A=Chirp-Up; B=Chirp down) ist durch Schraffurlinien von oben links nach unten rechts bzw. von unten links nach oben rechts markiert ist.

In Fig. 3d wird das Prinzip der symbolischen Signalübertragung erläutert. Statt des Signals aus Figur 3c werden hier beispielhaft nur zwei Typen von (Dreiecks-)Signalobjekten übertragen. Konkret sind das ein erstes Dreiecksobjekt (A) (in Fig. 3d sowohl für den Chirp-Up-Fall als auch den Chirp-Down-Fall gezeigt) und ein zweites Dreiecksobjekt (B) (für den Chirp-Down-Fall gezeigt). Gleichzeitig werden der Zeitpunkt und die Scheitelwerte sowie ggfs. auch die Basisbreite des Dreiecksobjekts übertragen. Erfolgt nun auf Basis dieser Daten eine Rekonstruktion des Signals, so erhält man ein Signal entsprechend Figur 3d. Aus diesem Signal wurden die Signalanteile entfernt, die nicht den Dreiecksignalen entsprachen. Damit sind nicht erkannte Signalanteile verworfen worden, was zu einer massiven Datenkompression führt.

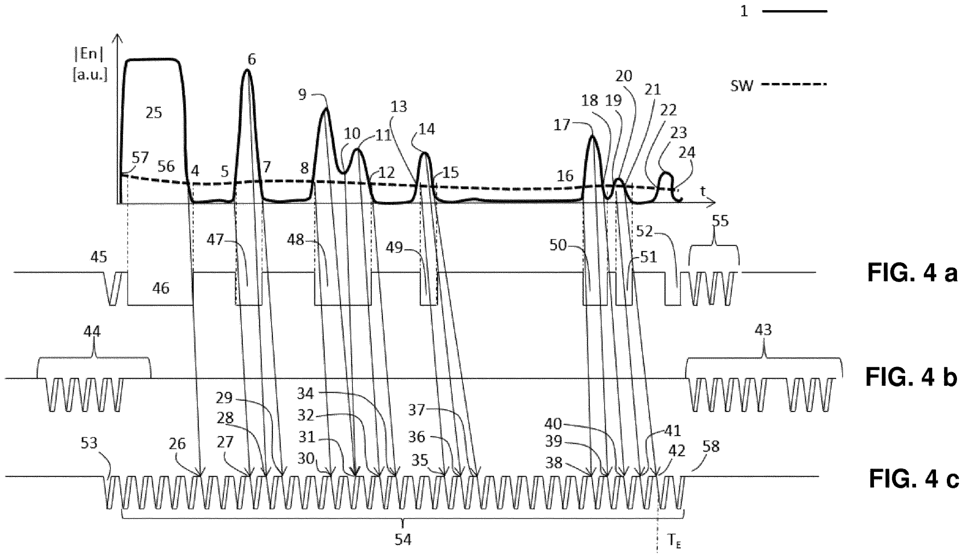

Fig. 4a zeigt die nicht beanspruchte konventionelle analoge Übertragung der Schnittpunkte des Hüllkurvensignals (1) des Ultraschall-Echo-Signals mit dem Schwellwertsignal (SW).

Fig. 4b zeigt die nicht beanspruchte Übertragung analysierter Daten nach vollständigem Empfang des Ultraschallechos.

Fig. 4c zeigt die beanspruchte Übertragung komprimierter Daten, wobei in diesem Beispiel Symbole für Signalgrundobjekte weitestgehend ohne Kompression übertragen werden.

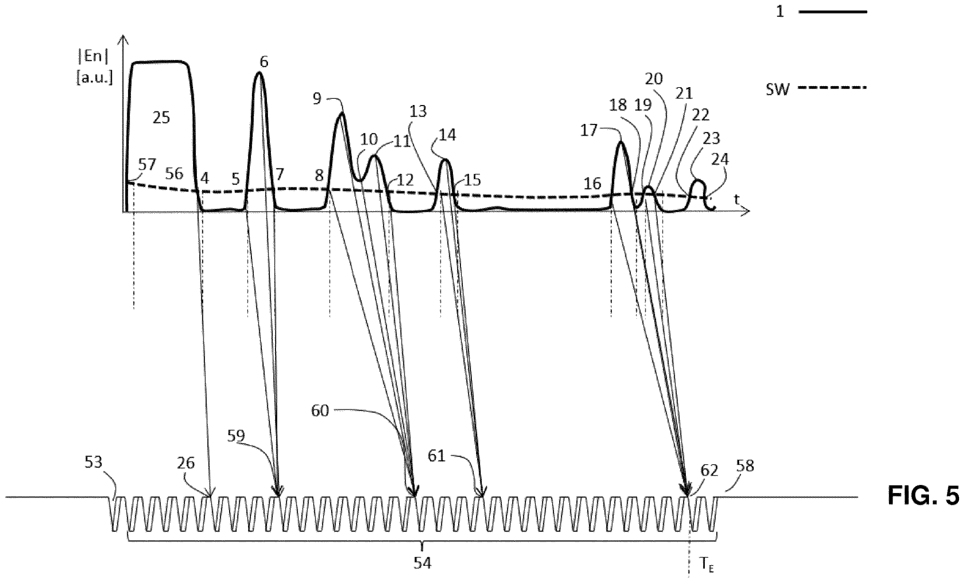

Fig. 5 zeigt die beanspruchte Übertragung komprimierter Daten, wobei in diesem Beispiel Symbole für Signalgrundobjekte zu Symbolen für Signalobjekte komprimiert werden. Zuerst wird ein erstes Dreiecksobjekt (59), das charakterisiert ist durch die zeitliche Abfolge aus der Schwellwertüberschreitung, dem Maximum und der Schwellwertunterschreitung (siehe die zeitliche Abfolge der Signalverlaufspunkte 5, 6, 7 im Zeitverlauf des Ultraschall-Echosignals im oberen Diagramm der Fig. 5), erkannt und übertragen. Dann wird eine Doppelspitze mit Sattelpunkt (60) über dem Schwellwertsignal erkannt. Charakteristisch ist hier die Abfolge aus der Überschreitung des Schwellwertsignals (SW) durch das Hüllkurvensignals (1), dem Maximum des Hüllkurvensignals (1), dem Minimum oberhalb des Schwellwertsignals (SW), dem Maximum oberhalb des Schwellwertsignals (SW) und der Unterschreitung des Schwellwertsignals (SW) (siehe im oberen Diagramm die Signalverlaufspunkte 8, 9, 10, 11, 12). Nach der Erkennung wird das Symbol für diese Doppelspitze mit Sattelpunkt übertragen. Dabei wird ein Zeitstempel mitübertragen. Bevorzugt werden auch weitere Parameter der Doppelspitze mit Sattelpunkt mitübertragen wie z.B. die Positionen der Maxima und des Minimums oder ein Skalierungsfaktor. Es folgt dann wieder die Erkennung eines Dreiecksignals (61) (d. h. eines Signalgrundobjekts) als Überschreitung des Schwellwertsignals (SW) durch das Hüllkurvensignal gefolgt von dem Maximum des Hüllkurvensignals, wiederum gefolgt von dem Unterschreiten des Schwellwertsignals (SW) durch das Hüllkurvensignal (siehe im oberen Diagramm die Signalverlaufspunkte 13, 14, 15). Es folgt dann wieder die Erkennung einer Doppelspitze (62), wobei nun aber das Minimum des Hüllkurvensignals unter dem Schwellwertsignal (SW) liegt (siehe im oberen Diagramm die Signalverlaufspunkte 16, 17, 18, 19, 20, 21). Diese Doppelspitze kann also beispielsweise als separates Signalobjekt behandelt werden. Als letztes wird das Dreiecksignal aus den Signalverlaufspunkten 22, 23, 24 des obigen Diagramms erkannt. Wie leicht erkennbar, führt diese Behandlung des Signals zu einer massiven Datenreduktion.

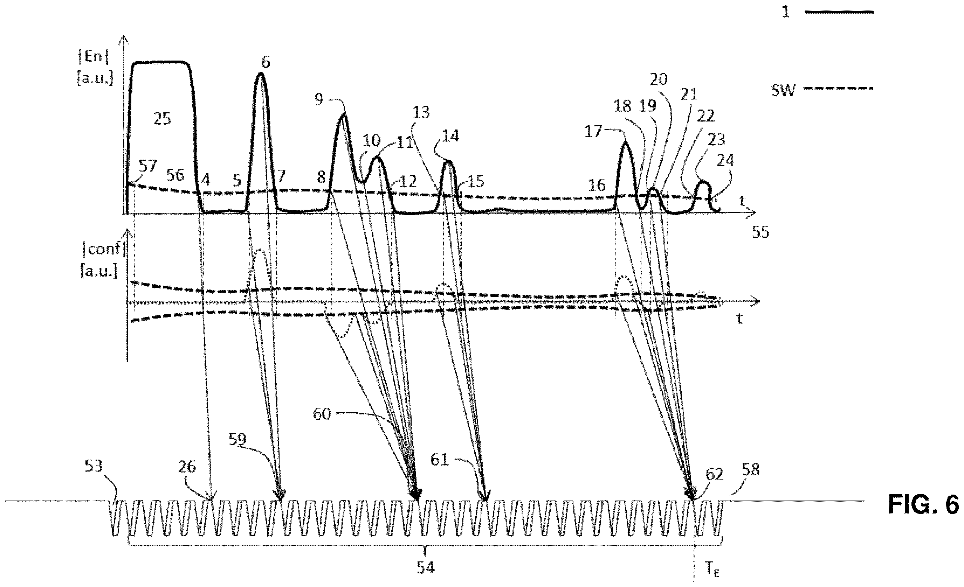

Fig. 6 zeigt die beanspruchte Übertragung komprimierter Daten entsprechend Fig. 3, wobei in diesem Beispiel nicht nur das Hüllkurvensignal, sondern auch ein Confidenz-Signal ausgewertet wird. Im oberen und mittleren Diagramm der Fig. 6 sind mit dicken gestrichelten Linien Schwellwertsignale angegeben. Wie zu erkennen ist, wird das Empfangssignal erst dann ausgewertet, wenn es das Schwellwertsignal überschreitet. Die gepunktete Signalverlaufslinie im mittleren Diagramm der Fig. 6 zeigt an, dass ein Signalobjekt als mit Chirp-up moduliert oder mit Chirp-down moduliert ist (siehe hierzu auch die Fign. 3c und 3d, in denen durch die verschieden schrägstehenden Schraffuren zwischen Chirp-up und Chirp-down unterschieden wird). Ein gepunkteter Signallinienverlauf nach oben besagt, dass das Signalobjekt als Chirp-up moduliert erkannt worden ist, während ein gepunkteter Signallinienverlauf nach unten besagt, dass das Signalobjekt als Chirp-down moduliert erkannt worden ist.

Für das Vorstehende und Nachfolgend gilt es zu beachten, dass die Begrifflichkeiten wie folgt definiert sind:
- Signalobjekt wird auch als Signalverlaufsobjekt bezeichnet
- Signalobjektklasse wird auch als Signalverlaufsobjektklasse bezeichnet
- Symbol ist die Kennung der Signalverlaufsobjektklasse
- Signalobjektparameter ist gleichbedeutend mit Objektparameter
- Signalgrundform meint ein Signalverlaufscharakteristikum Definitionsgemäß besteht ein Signalobjekt aus einem oder mehreren Signalgrundobjekten, d. h. ein Signalverlaufsobjekt besteht aus ein oder mehrere Signalverlaufscharakteristika. Ein Signalobjekt gehört zu einer von mehreren Signalobjektklassen. Ein Signalobjekt kann beschrieben werden durch einen oder mehrere Signalobjektparameter, und zwar hinsichtlich z. B. Lage, Größe, Verzerrung und Streckung.

Ein Signalgrundobjekt kann auch als Signalverlaufsgrundmerkmal, d. h. Signalverlaufscharakteristikum bezeichnet werden.

Parameter beschreiben zusätzlich die Form des Signalobjekts.

Ein Parametersignal besteht aus mehreren Parametersignalwerten.

Ein Feature-Vektor-Signal besteht aus mehreren Parametersignalen.

Ein Wert des Feature-Vektor-Signals besteht aus mehreren Parametersignalwerten.

Mehrere Parametersignale bilden das Feature-Vektor-Signal. Ein Feature-Vektor-Signalwert, der auch als Parameter-Vektor-Signalwert bezeichnet wird, umfasst mehrere Parametersignalwerte.

Einzelne Ausgestaltungen der Erfindung werden nachfolgend angegeben, wobei anzumerken ist, dass die nachfolgend angegebenen Einzelgruppen von Merkmalen beliebig untereinander kombiniert werden können (die Bezugszeichen beziehen sich auf die Darstellungen in den Fign. 1 und 2 und sind lediglich beispielhaft, also nicht einschränkend zu verstehen), wobei anzumerken ist, dass die Erfindung in den Ansprüchen definiert ist.

### BEZUGSZEICHENLISTE

- α: Aussenden des Ultraschall-Bursts
- β: Empfangen des an einem Objekt reflektierten Ultraschall-Bursts und Umwandlung in ein elektrisches Empfangssignal
- γ: Kompression des elektrischen Empfangssignals und Bildung eines abgetasteten elektrischen Empfangssignals, wobei bevorzugt jedem Abtastwert des elektrischen Empfangssignals ein Zeitstemple zugeordnet werden kann
- γb: Ermittlung von mehreren Spektralwerten z.B. durch Optimalfilter (englisch Matched Filter) für Signalobjektklassen. Diese mehreren Spektralwerte bilden zusammen einen Feature-Vektor. Diese Bildung findet bevorzugt fortlaufend statt, so dass sich ein Strom von Feature-Vektor-Werten ergibt. Jedem Feature-Vektor-Wert kann bevorzugt wieder ein Zeitstempelwert zugeordnet werden
- yc: optionale, aber bevorzugt durchgeführte Normierung der Feature-Vektor Spektralkoeffizienten des jeweiligen Feature-Vektors eines Zeitstempelwerts vor der Korrelation mit den Signalobjektklassen in Form von vorgegebenen Feature-Vektor-Werten einer Prototypen-Bibliothek
- yd: Abstandsbestimmung zwischen dem aktuellen Feature-Vektor-Wert und den Werten der Signalobjektklassen in Form von vorgegebenen FeatureVektor-Werten einer Prototypen-Bibliothek
- γe: Selektion der ähnlichsten Signalobjektklasse in Form eines vorgegebenen Feature-Vektor-Wertes einer (Prototypen-)Bibliothek mit bevorzugt minimalem Abstand zum aktuellen Feature-Vektor und Übernahme des Symbols dieser Signalobjektklasse als erkanntes Signalobjekt zusammen mit dem Zeitstempelwert als komprimierte Daten. Ggfs. können weitere Daten, insbesondere Signalobjektparameter, wie z.B. dessen Amplitude als komprimierte Daten mitübernommen werden. Diese komprimierten Daten bilden dann die Komprimierung des Empfangssignals
- δ: Übertragung des komprimierten elektrischen Empfangssignals an das Rechnersystem:
- 1: Hüllkurve des empfangenen Ultraschallsignals
- 2: Ausgangssignal (übermittelte Information) einer IO-Schnittstelle gemäß dem Stand der Technik
- 3: übermittelte Information einer LIN-Schnittstelle gemäß dem Stand der Technik
- 4: erster Schnittpunkt der Hüllkurve 1 des Empfangssignals mit dem Schwellwertsignal SW in Abwärtsrichtung
- 5: erster Schnittpunkt der Hüllkurve 1 mit dem Schwellwertsignal SW in Aufwärtsrichtung
- 6: erstes Maximum der Hüllkurve 1 oberhalb der Schwellwertsignals SW
- 7: zweiter Schnittpunkt der Hüllkurve 1 mit dem Schwellwertsignal SW in Abwärtsrichtung
- 8: zweiter Schnittpunkt der Hüllkurve 1 mit dem Schwellwertsignal SW in Aufwärtsrichtung
- 9: zweites Maximum der Hüllkurve 1 oberhalb des Schwellwertsignals SW
- 10: erstes Minimum der Hüllkurve 1 oberhalb des Schwellwertsignals SW
- 11: drittes Maximum der Hüllkurve 1 oberhalb des Schwellwertsignals SW
- 12: dritter Schnittpunkt der Hüllkurve 1 mit dem Schwellwertsignal SW in Abwärtsrichtung
- 13: dritter Schnittpunkt der Hüllkurve 1 mit dem Schwellwertsignal SW in Aufwärtsrichtung
- 14: viertes Maximum der Hüllkurve 1 oberhalb des Schwellwertsignals SW
- 15: vierter Schnittpunkt der Hüllkurve 1 mit dem Schwellwertsignal SW in Abwärtsrichtung
- 16: vierter Schnittpunkt der Hüllkurve 1 mit dem Schwellwertsignal SW in Aufwärtsrichtung
- 17: fünftes Maximum der Hüllkurve 1 oberhalb des Schwellwertsignals SW
- 18: fünfter Schnittpunkt der Hüllkurve 1 mit dem Schwellwertsignal SW in Abwärtsrichtung
- 19: fünfter Schnittpunkt der Hüllkurve 1 mit dem Schwellwertsignal SW in Aufwärtsrichtung
- 20: sechstes Maximum der Hüllkurve 1 oberhalb des Schwellwertsignals SW
- 21: sechster Schnittpunkt der Hüllkurve 1 mit dem Schwellwertsignal SW in Abwärtsrichtung
- 22: sechster Schnittpunkt der Hüllkurve 1 mit dem Schwellwertsignal SW in Aufwärtsrichtung
- 23: siebtes Maximum der Hüllkurve 1 oberhalb des Schwellwertsignals SW
- 24: siebter Schnittpunkt der Hüllkurve 1 mit dem Schwellwertsignal SW in Abwärtsrichtung
- 25: Hüllkurve während des Ultraschall-Bursts
- 26: Übertragung der Daten des ersten Schnittpunkts 4 der Hüllkurve 1 mit dem Schwellwertsignal SW in Abwärtsrichtung über den vorzugsweise bidirektionalen Datenbus
- 27: Übertragung der Daten des ersten Schnittpunkts 5 der Hüllkurve 1 mit dem Schwellwertsignal SW in Aufwärtsrichtung über den vorzugsweise bidirektionalen Datenbus
- 28: Übertragung der Daten des ersten Maximums 6 der Hüllkurve 1 oberhalb des Schwellwertsignals SW über den vorzugsweise bidirektionalen Datenbus
- 29: Übertragung der Daten des zweiten Schnittpunkts 7 der Hüllkurve 1 mit dem Schwellwertsignal SW in Abwärtsrichtung über den vorzugsweise bidirektionalen Datenbus
- 30: Übertragung der Daten des zweiten Schnittpunkts 8 der Hüllkurve 1 mit dem Schwellwertsignal SW in Aufwärtsrichtung über den vorzugsweise bidirektionalen Datenbus
- 31: Übertragung der Daten des zweiten Maximums 9 der Hüllkurve 1 oberhalb des Schwellwertsignals SW und der Daten des beispielhaften ersten Minimums 10 der Hüllkurve 1 oberhalb des Schwellwertsignals SW über den vorzugsweise bidirektionalen Datenbus
- 32: Übertragung der Daten des dritten Maximums 1 der Hüllkurve 1 oberhalb des Schwellwertsignals SW über den vorzugsweise bidirektionalen Datenbus
- 34: Übertragung der Daten des dritten Schnittpunkts 12 der Hüllkurve 1 mit dem Schwellwertsignal SW in Abwärtsrichtung über den vorzugsweise bidirektionalen Datenbus
- 35: Übertragung der Daten des dritten Schnittpunkts 13 der Hüllkurve 1 mit dem Schwellwertsignal SW in Aufwärtsrichtung über den vorzugsweise bidirektionalen Datenbus
- 36: Übertragung der Daten des vierten Maximums 14 der Hüllkurve 1 oberhalb des Schwellwertsignals SW über den vorzugsweise bidirektionalen Datenbus
- 37: Übertragung der Daten des vierten Schnittpunkts 15 der Hüllkurve 1 mit dem Schwellwertsignal SW in Abwärtsrichtung über den vorzugsweise bidirektionalen Datenbus
- 38: Übertragung der Daten des vierten Schnittpunkts 16 der Hüllkurve 1 mit dem Schwellwertsignal SW in Aufwärtsrichtung über den vorzugsweise bidirektionalen Datenbus
- 39: Übertragung der Daten des fünften Maximums 17 der Hüllkurve 1 oberhalb des Schwellwertsignals SW über den vorzugsweise bidirektionalen Datenbus
- 40: Übertragung der Daten des fünften Schnittpunkts 18 der Hüllkurve 1 mit dem Schwellwertsignal SW in Abwärtsrichtung über den vorzugsweise bidirektionalen Datenbus
- 41: Übertragung der Daten des fünften Schnittpunkts 19 der Hüllkurve 1 mit dem Schwellwertsignal SW in Aufwärtsrichtung über den vorzugsweise bidirektionalen Datenbus
- 42: Übertragung der Daten des sechsten Schnittpunkts 21 der Hüllkurve 1 mit dem Schwellwertsignal SW in Abwärtsrichtung über den vorzugsweise bidirektionalen Datenbus
- 43: Übertragung der Daten der empfangenen Echos auf dem LIN-Bus nach dem Stand der Technik nach Ende des Empfangs
- 44: Übertragung von Daten auf dem LIN-Bus nach dem Stand der Technik vor Aussendung des Ultraschall-Bursts
- 45: Übertragung von Daten über die IO-Schnittstelle nach dem Stand der Technik vor Aussendung des Ultraschall-Bursts
- 46: Wirkung des Ultraschall-Sende-Bursts auf das Ausgangssignal der IO-Schnittstelle nach dem Stand der Technik
- 47: Signal des ersten Echos 5, 6, 7 auf der IO-Schnittstelle gemäß dem Stand der Technik
- 48: Signal des zweiten Echos 8, 9, 10, 11, 12 auf der IO-Schnittstelle gemäß dem Stand der Technik
- 49: Signal des dritten und vierten Echos 13, 14, 15 auf der IO-Schnittstelle gemäß dem Stand der Technik
- 50: Signal des fünften Echos 16, 17, 18 auf der IO-Schnittstelle gemäß dem Stand der Technik
- 51: Signal des sechsten Echos 19, 20, 21 auf der IO-Schnittstelle gemäß dem Stand der Technik
- 52: Signal des siebten Echos 22, 23, 24 auf der IO-Schnittstelle gemäß dem Stand der Technik
- 53: Startbefehl von dem Rechnersystem an den Sensor über den Datenbus
- 54: periodische automatische Datenübertragung zwischen Sensor und Rechnersystem vorzugsweise nach DSI3-Standard
- 55: Diagnose-Bits nach dem Messzyklus
- 56: Ende des Aussendens des Ultraschall-Bursts (Ende des Sende-Bursts). Bevorzugt fällt das Ende des Ultraschall-Bursts mit dem Punkt 4 zusammen
- 57: Anfang des Aussendens des Ultraschall-Bursts (Anfang des Sende-Bursts)
- 58: Ende der Datenübertragung
- a: Übertragene Informationen für die Übertragung der empfangenen Ultraschallechos mittels einer IO-Schnittstelle aus dem Stand der Technik
- A: erstes Dreiecksobjekt
- a.u.: "arbritrary units" = frei gewählte Einheiten
- B: zweites Dreiecksobjekt
- b: Übertragene Informationen für die Übertragung der empfangenen Ultraschallechos mittels einer LIN-Schnittstelle aus dem Stand der Technik
- c: Übertragene Informationen für die Übertragung der empfangenen Ultraschallechos mittels des vorgeschlagenen Verfahrens und der vorgeschlagenen Vorrichtung mit Hüllkurve zum Vergleich
- d: Übertragene Informationen für die Übertragung der empfangenen Ultraschallechos mittels des vorgeschlagenen Verfahrens und der vorgeschlagenen Vorrichtung ohne Hüllkurve
- e: schematische Signalformen bei der Übertragung der empfangenen Echo-Informationen mittels einer IO-Schnittstelle aus dem Stand der Technik
- En: Amplitude der Hüllkurve des empfangenen Ultraschallsignals
- f: schematische Signalformen bei der Übertragung der empfangenen Echo-Informationen mittels einer LIN-Schnittstelle aus dem Stand der Technik
- g: schematische Signalformen bei der Übertragung der empfangenen Echo-Informationen mittels einer bidirektionalen Datenschnittstelle
- SB: Sende-Burst
- SW: Schwelle
- t: Zeit
- T_{E}: Empfangszeit. Die Empfangszeit beginnt typischerweise mit dem Ende 56 des Aussendens des Ultraschall-Bursts. Es ist möglich, mit dem Empfang bereits zuvor zu beginnen. Dies kann aber zu Problemen führen die gegebenenfalls zusätzliche Maßnahmen erfordern.

## Patentansprüche

1. Verfahren zur Übertragung von Daten über einen Fahrzeugdatenbus von einem Ultraschallsystem mit mindestens zwei Sensoren mit jeweils einem Ultraschallsender und einem Ultraschallempfänger an ein eine Datenverarbeitungsvorrichtung aufweisendes Rechnersystem zur Verarbeitung der übertragenen Daten, wobei bei dem Verfahren
- zum Übertragen der Daten pro Sensor an das Rechnersystem,
- aus einem von dem mindestens einen Ultraschallempfänger des Ultraschallsystems empfangenen Echosignal vorgegebene Signalverlaufscharakteristika extrahiert werden,
- anhand einer Gruppe von extrahierten Signalverlaufscharakteristika ein Signalverlaufsobjekt im Echosignal identifiziert wird,
- jedes identifizierte Signalverlaufsobjekt einer von mehreren vorgegebenen Signalverlaufsobjektklassen zugeordnet wird, von denen jede durch eine Kennung spezifiziert ist,
- zu jedem identifizierten Signalverlaufsobjekt mindestens ein dieses beschreibender Objektparameter ermittelt wird,
- wobei der mindestens eine Objektparameter
- der auf einen Referenzzeitpunkt bezogene Auftrittzeitpunkt des Signalverlaufsobjekts,
- die zeitliche Ausdehnung des Signalverlaufsobjekts,
- der zeitliche Abstand zu einem im Echosignal vorauseilenden oder nachfolgenden Signalverlaufsobjekt,
- die Größe, die Höhe und insbesondere die Maximalhöhe des Signalverlaufsobjekts,
- der Zeitpunkt der Höhe und insbesondere der Zeitpunkt der maximalen Höhe des Signalverlaufsobjekts innerhalb von dessen zeitlicher Ausdehnung und/oder
- die Größe der Fläche des zum Signalverlaufsobjekt gehörenden Echosignalabschnitts und insbesondere die Größe des oberhalb eines Schwellwerts oder eines Schwellwertsignalverlaufs liegenden Anteils der Fläche des zum Signalverlaufsobjekt gehörenden Echosignalabschnitts ist,
- aus der Kennung für die Signalverlaufsobjektklasse und dem oder den zu einem Signalverlaufsobjekt ermittelten Objektparametern der zum Signalverlaufsobjekt gehörende Echosignalabschnitt rekonstruierbar ist und
- von dem Ultraschallsystem für ein identifiziertes Signalverlaufsobjekt über den Fahrzeugdatenbus die Kennung und der oder die Objektparameter als im Vergleich zu den von den Sensoren gelieferten, das Echosignal beschreibenden Daten komprimierte, die Echosignalabschnitte der Signalverlaufsobjekte repräsentierende Echosignalabschnittsdaten zwecks Erkennung eines Hindernisses und/oder des Abstandes zwischen einem Hindernis und dem mindestens einen Ultraschallempfänger des Ultraschallsystems oder einem der Ultraschallempfänger des Ultraschallsystems an das Rechnersystem übertragen werden und
- zur Verarbeitung der Daten in dem Rechnersystem
- die die Echosignalabschnitte der Signalverlaufsobjekte repräsentierenden, komprimierten Echosignalabschnittsdaten durch Dekompression zu rekonstruierten Ultraschallempfangssignalen rekonstruiert werden und
- mit Hilfe der rekonstruierten Ultraschallempfangssignale eine Erkennung von Hindernissen im Umfeld der Sensoren durchgeführt wird.

2. Verfahren nach Anspruch 1, **dadurch gekennzeichnet, dass** von den Ultraschallempfängern der Sensoren über den Fahrzeugdatenbus die Echosignalabschnittsdaten, die aus mehreren in einem vorgebbaren Zeitfenster empfangenen Echosignalen jeweils identifizierte Signalverlaufsobjekten repräsentieren, an die Datenverarbeitungsvorrichtung des Rechnersystem zwecks Erkennung eines Hindernisses und/oder des Abstandes eines Hindernisses zu mindestens einem Ultraschallempfänger oder einem der Ultraschallempfänger des Ultraschallsystems übertragen werden.

3. Verfahren nach Anspruch 1 oder 2, **dadurch gekennzeichnet, dass** über den Fahrzeugdatenbus von den Ultraschallempfängern der Sensoren an die Datenverarbeitungsvorrichtung zusätzlich zu den Echosignalabschnittsdaten auch den jeweiligen identifizierten Signalverlaufsobjekten zugeordnete Konfidenzwerte übertragen werden.

4. Verfahren nach einem der Ansprüche 1 bis 3, **dadurch gekennzeichnet, dass** ein Signalverlaufscharakteristikum ein oberhalb eines Schwellwerts oder eines Schwellwertsignals liegender lokaler Extremwert des Echosignals mit Auftrittzeitpunkt, ein oberhalb eines Schwellwerts oder eines Schwellwertsignals liegender absoluter Extremwert des Echosignals mit Auftrittzeitpunkt, ein oberhalb eines Schwellwerts oder eines Schwellwertsignals liegender Sattelpunkt des Echosignals mit Auftrittzeitpunkt, ein bei größer werdendem Signalpegel des Echosignals erfolgendes Überschreiten eines oder des Schwellwerts oder eines oder des Schwellwertsignals mit Überschreitungszeitpunkt und/oder ein bei kleiner werdendem Signalpegel des Echosignals erfolgendes Unterschreiten eines oder des Schwellwerts oder eines oder des Schwellwertsignals mit Unterschreitungszeitpunkt oder vorgebbare Kombinationen aus ein oder mehreren der zuvor genannten Signalverlaufscharakteristika, die zeitlich aufeinanderfolgend auftreten, ist.

5. Sensorsystem mit
- mindestens einem Rechnersystem und
- mindestens zwei Sensoren,
- wobei die mindestens zwei Sensoren und das mindestens eine Rechnersystem zur Datenübertragung und -verarbeitung nach dem Verfahren gemäß einer der Ansprüche 1 bis 4 ausgelegt sind.

6. Sensorsystem nach Anspruch 5, **dadurch gekennzeichnet, dass** das Rechnersystem dazu ausgelegt ist, zusätzlich mit Hilfe von Signalen weiterer Sensoren, insbesondere von Signalen von Radar-Sensoren, eine Erkennung von Hindernissen im Umfeld der Sensoren durchzuführen.

7. Sensorsystem nach Anspruch 5 oder 6, **dadurch gekennzeichnet, dass** das Rechnersystem dazu ausgelegt ist, auf Basis der erkannten Objekte eine Umfeldkarte für die Sensoren oder für eine Vorrichtung, zu der die Sensoren gehören oder die Sensoren aufweist, zu erstellen.

## Claims

1. A method for transmitting data via a vehicle data bus from an ultrasonic system having at least two sensors each with one ultrasonic transmitter and one ultrasonic receiver to a computer system comprising a data processing device for processing the transmitted data, wherein, in the method,
- for transmitting the data per sensor to the computer system
- predetermined signal profile characteristics are extracted from an echo signal received by the at least one ultrasonic receiver of the ultrasonic system,
- a signal profile object is identified in the echo signal based on a group of extracted signal profile characteristics,
- each identified signal profile object is allocated to one of a plurality of predetermined signal profile object classes, each of which is specified by an identifier,
- for each identified signal profile object at least one object parameter describing the same is determined,
- wherein the at least one object parameter is
- the time of occurrence of the signal profile object relative to a reference time,
- the temporal extent of the signal profile object,
- the time lag relative to a signal profile object preceding or trailing in the echo signal
- the magnitude,
- the peak and in particular the maximum peak of the signal profile object,
- the time of the peak and in particular the time of the maximum peak of the signal profile object within its temporal extent, and/or
- the size of the area of the echo signal section belonging to the signal profile object and in particular the size of the proportion of the area of the echo signal section belonging to the signal profile object above a threshold value or a threshold signal profile,
- the echo signal section belonging to the signal profile object can be reconstructed from the identifier of the signal profile object class and the object parameter(s) determined for a signal profile object, and
- for an identified signal profile object, the ultrasonic system transmits to the computer system, via the vehicle data bus, the identifier and the object parameter(s) as, in comparison with the data describing the echo signal and supplied by the sensors, compressed echo signal section data representing the echo signal section of the signal profile object for the purpose of detecting an obstacle and/or a distance between an obstacle and the at least one ultrasonic receiver of the ultrasonic system or one of the ultrasonic receivers of the ultrasonic system,
- for processing the data in the computer system,
- the compressed echo signal section data representing the echo signal sections of the signal profile objects are reconstructed by decompression to reconstructed received ultrasonic signals, and
- a recognition of obstacles in the environment of the sensors is performed on the basis of the reconstructed received ultrasonic signals.

2. The method of claim 1, **characterized in that** the echo signal section data, which represent signal profile objects respectively identified from a plurality of echo signals received in a predeterminable time slot, are transmitted from the ultrasonic receivers of the sensors to the data processing device of the computer system via the vehicle data bus for the purpose of detecting an obstacle and/or the distance of an obstacle to at least one ultrasonic receiver or one of the ultrasonic receivers of the ultrasonic system.

3. The method of claim 1 or 2, **characterized in that**, in addition to the echo signal section data, confidence values allocated to the respective identified signal profile objects are transmitted from the ultrasonic receivers of the sensors to the data processing device via the vehicle data bus.

4. The method of any one of claims 1 to 3, **characterized in that** a signal profile characteristic is a local extreme value of the echo signal with a time of occurrence, which value is above the threshold value or a threshold value signal; an absolute extreme value of the echo signal with a time of occurrence, which value is above the threshold value or a threshold value signal; a saddle point of the echo signal with a time of occurrence, which saddle point is above the threshold value or a threshold value signal; an exceeding of a or the threshold value or of a or the threshold value signal with a time of exceeding, which exceeding occurs as the signal level of the echo signal increases, and/or an undershooting of a or the threshold value or of a or the threshold value signal with a time of undershooting, which undershooting occurs as the signal level of the echo signal decreases, or a predeterminable combinations of one or a plurality of the above-mentioned signal profile characteristics which occur in chronological sequence.

5. A sensor system comprising
- at least one computer system, and
- at least two sensors,
- wherein the at least two sensors and the at least one computer system are configured for data transmission and processing according to the method of any one of claims 1 to 4.

6. The sensor system of claim 5, **characterized in that** the computer system is configured to perform a recognition of obstacles in the environment of the sensors, in addition using sensor signals of further sensors, in particular signals from radar sensors.

7. The sensor system of claim 5 or 6, **characterized in that** the computer system is configured to create an environment map for the sensors or for a device of which the sensors are a part or which comprises the sensors, on the basis of the recognized objects.

## Revendications

1. Procédé pour la transmission de données par le biais d'un bus de données de véhicule depuis un système à ultrasons doté d'au moins deux capteurs avec respectivement un émetteur d'ultrasons et un récepteur d'ultrasons vers un système calculateur comportant un dispositif de traitement de données pour le traitement des données transmises, dans lequel lors du procédé
- afin de transmettre les données par capteur au calculateur,
- des caractéristiques de forme d'onde prédéfinies sont extraites d'un signal d'écho reçu par l'au moins un récepteur d'ultrasons du système à ultrasons,
- un objet de forme d'onde est identifié dans le signal d'écho à l'aide d'un groupe de caractéristiques de forme d'onde extraites,
- chaque objet de forme d'onde identifié est associé à une parmi plusieurs classes d'objets de forme d'onde, chacune d'entre elles étant spécifiée par une désignation,
- un de ces paramètres d'objet décrits est déterminé pour chaque objet de forme d'onde identifié,
- dans lequel l'au moins un paramètre d'objet est
- l'instant d'apparition de l'objet de forme d'onde par rapport à un instant de référence,
- l'étendue temporelle de l'objet de forme d'onde,
- l'écart temporel par rapport à un objet de forme d'onde précédent ou consécutif dans le signal d'écho,
- la taille, la hauteur et en particulier la hauteur maximale de l'objet de forme d'onde,
- l'instant de la hauteur et en particulier l'instant de la hauteur maximale de l'objet de forme d'onde au sien de l'étendue temporelle de celui-ci et/ou
- la taille de la surface de la section de signal appartenant à l'objet de forme d'onde et en particulier la taille de la fraction de la surface de la section de signal appartenant à l'objet de forme d'onde se trouvant au-dessus d'une valeur seuil ou d'une forme d'onde de valeur seuil,
- la section de signal d'écho appartenant à l'objet de forme d'onde peut être reconstituée à partir de la désignation pour la classe d'objets de forme d'onde et du ou des paramètre(s) d'objet déterminé(s) pour un objet de forme d'onde et
- pour un objet de forme d'onde identifié, la désignation et le ou les paramètre(s) d'objet sont transmises au calculateur par le biais du bus de données de véhicule en tant que données de sections de signal d'écho représentant les sections de signal d'écho des objets de forme d'onde comprimées par rapport aux données fournies par les capteurs et décrivant le signal d'écho, à des fins de reconnaissance d'un obstacle et/ou de la distance entre un obstacle et l'au moins un récepteur d'ultrasons du système à ultrasons ou un des récepteurs d'ultrasons du système à ultrasons et
- pour le traitement des données dans le calculateur
- les données de sections de signal d'écho comprimées et représentant les sections de signal d'écho des objets de forme d'onde sont reconstituées en signaux de réception d'ultrasons reconstitués par décompression et
- une reconnaissance d'obstacles dans l'environnement des capteurs est effectuée à l'aide des signaux de réception d'ultrasons reconstitués.

2. Procédé selon la revendication 1, **caractérisé en ce que** les données de section de signal d'écho qui représentent des objets de forme d'onde respectivement identifiés parmi plusieurs signaux d'échos reçus dans un intervalle de temps pouvant être prédéfini, sont transmises depuis les récepteurs à ultrasons des capteurs par le biais du bus de données de véhicule au dispositif de traitement de données du calculateur à des fins de reconnaissance d'un obstacle et/ou de la distance entre un obstacle et l'au moins un récepteur d'ultrasons du système à ultrasons ou un des récepteurs d'ultrasons du système à ultrasons.

3. Procédé selon la revendication 1 ou 2, **caractérisé en ce qu'**outre les données de section de signal d'écho, les valeurs de confiance respectivement associées aux objets de forme d'onde identifiés sont également transmises depuis les récepteurs à ultrasons des capteurs par le biais du bus de données de véhicule au dispositif de traitement de données.

4. Procédé selon l'une des revendications 1 à 3, **caractérisé en ce qu'**une caractéristique de forme d'onde est un extremum local du signal d'écho, au-dessus d'une valeur seuil ou d'un signal de valeur seuil, avec instant d'apparition, un extremum absolu du signal d'écho, au-dessus d'une valeur seuil ou d'un signal de valeur seuil, avec instant d'apparition, un extremum absolu du signal d'écho, au-dessus d'une valeur seuil ou d'un signal de valeur seuil, avec instant d'apparition, un point col du signal d'écho, au-dessus d'une valeur seuil ou d'un signal de valeur seuil, avec instant d'apparition, un dépassement d'une ou de la valeur seuil ou d'un ou du signal de valeur seuil se produisant lorsque qu'un niveau de signal augmente avec instant de dépassement et/ou un sous-dépassement d'une ou de la valeur seuil ou d'un ou du signal de valeur seuil se produisant lorsque qu'un niveau de signal diminue avec instant de sous-dépassement ou des combinaisons pouvant être prédéfinies d'une ou plusieurs des caractéristiques de forme d'onde nommées ci-dessus apparaissant de manière chronologiquement consécutive.

5. Système de capteurs doté
- d'au moins un calculateur et
- d'au moins deux capteurs,
- dans lequel les au moins deux capteurs et l'au moins un calculateur sont disposés pour la transmission et le traitement de données d'après le procédé selon l'une des revendications 1 à 4.

6. Système de capteurs selon la revendication 5, **caractérisé en ce que** le calculateur est disposé de façon à effectuer une reconnaissance d'obstacles dans l'environnement des capteurs, avec l'aide ultérieure des signaux de capteurs supplémentaires, en particulier des signaux de capteurs radar.

7. Système de capteurs selon la revendication 5 ou 6, **caractérisé en ce que** le calculateur est disposé de façon à établir une carte de l'environnement pour les capteurs ou pour un dispositif auquel appartiennent les capteurs ou qui comporte les capteurs, sur la base des objets reconnus.
